# EUROPÄISCHE PATENTSCHRIFT

(11) **EP 3 861 361 B1**
(45) Veröffentlichungstag und Bekanntmachung des Hinweises auf die Patenterteilung: **30.11.2022**
(21) Anmeldenummer: 19783474.0
(22) Anmeldetag: 01.10.2019
(51) Int. Cl.: G01R 31/00, G01R 31/28

(54) **VERFAHREN UND VORRICHTUNG ZUM ÜBERWACHEN DER ZUVERLÄSSIGKEIT EINES ELEKTRONISCHEN SYSTEMS**
METHOD AND DEVICE FOR MONITORING THE RELIABILITY OF AN ELECTRONIC SYSTEM
PROCÉDÉ ET DISPOSITIF SERVANT À SURVEILLER LA FIABILITÉ D'UN SYSTÈME ÉLECTRONIQUE

(30) Priorität: 01.10.2018 DE 102018216863
(43) Veröffentlichungstag der Anmeldung: 11.08.2021
(73) Patentinhaber: VOLKSWAGEN AKTIENGESELLSCHAFT, 38440 Wolfsburg (DE)
(72) Erfinder: AAL, Andreas, 38104 Braunschweig (DE); BUSSE, Hosea, 07743 Jena (DE)
(74) Vertreter: Platzöder, Michael Christian
(86) Internationale Anmeldenummer: PCT/EP2019/076659
(87) Internationale Veröffentlichungsnummer: WO 2020/070169

(56) Entgegenhaltungen:
- DE-T2-602004 007 525
- US-A1- 2011 133 753
- US-A1- 2017 343 601
- US-B1- 6 269 326

## Beschreibung

Die vorliegende Erfindung betrifft ein Verfahren sowie eine Vorrichtung zum Überwachen der Zuverlässigkeit eines elektronischen Systems, insbesondere eines einzelnen elektronischen Bauelements, beispielsweise eines Halbleiterchips (z.B. System-on-Chip, SOC), oder eines mehrere elektronische Bauelemente aufweisenden elektronischen Systems, wie beispielsweise eines Chipsatzes oder einer eine Mehrzahl elektronischer Bauelemente aufweisenden Baugruppe. Bei dem zu überwachenden System kann es sich insbesondere um ein elektronisches System handeln, das zum Einsatz in der Fahrzeugtechnik, insbesondere als Bestandteil eines Fahrzeugs, wie etwa eines Automobils oder Kraftrads, bzw. eines Fahrzeugsubsystems, etwa einem Steuergerät (ECU) vorgesehen ist.

In einigen Anwendungsfällen werden solche elektronische Systeme Anforderungen und Belastungen ausgesetzt, für die sie ursprünglich gar nicht entwickelt wurden. Dies kann etwa der Fall sein, wenn ein Halbleiterchip oder Chipsatz, der für eine Vielzahl von verschiedensten Anwendungen einsetzbar ist, wie beispielsweise ein Mikrocontroller oder ein Chip zur Bereitstellung einer Kommunikationsschnittstelle, in einem Fahrzeug verbaut wird und somit den damit zusammenhängenden harten Lastanforderungen und Einsatzbedingungen, insbesondere bezüglich Vibration, Temperaturbereich und Temperaturschwankungen und/oder dem meist aggressivem chemischen Umfeld z.B. im Motorraum oder einer Abgasanlage eines Kraftfahrzeugs ausgesetzt wird. Hierbei wird unter einem Fahrzeug jedes bewegliche Objekt, insbesondere Verkehrsmittel, verstanden, das zur Beförderung einer oder mehrere Personen, Güter, Aktoren und/oder Sensoren geeignet ist. Das Fahrzeug kann auch Flugeigenschaften oder Schwimmeigenschaften aufweisen. Insbesondere ist ein Personenkraftwagen (PKW), ein Lastkraftwagen (LKW), ein Motorrad, ein Bus, ein Fahrrad oder ein Anhänger zu einem der vorausgehend genannten Fahrzeuge ein Fahrzeug im Sinne der Erfindung. Dies gilt insbesondere auch für die Zugeinheit sowie die Anhänger eines Zuges. Ebenso sind Wasserfahrzeuge, Luftfahrzeuge und Raumfahrzeuge, insbesondere Schiffe und Boote, Flugzeuge und Flugdrohnen sowie Raketen und Satelliten jeweils Fahrzeuge im Sinne der Erfindung.

Als Folge dessen können sich somit neue Ausfallmechanismen oder eine Dominanzverschiebung von bereits vorhandenen Ausfallmechanismen auf Basis des Betriebskonzepts für solche elektronischen Systeme ergeben, die sich negativ auf deren Zuverlässigkeit, insbesondere Langzeitzuverlässigkeit auswirken können. So können etwa Lötstellen, wie sie zum elektrischen Anschluss (und teilweise auch zur mechanischen Befestigung) elektronischer Bauelemente auf Schaltungsplatinen zum Einsatz kommen, Anschlusspins von elektronischen Bauelementen, insbesondere externe Anschlüsse von Chips, oder Leiterbahnen auf Schaltungsplatinen (PCB) korrodieren, und Strukturveränderungen unterliegen, die insbesondere zur Ausbildung von Mikrorissen führen können. Auch können unerwünschten Veränderungen bauteilintern durch Integritäts-, Degradations- oder Alterungseffekte (z. B. Delamination von Schichten, Elektromigration usw.) auftreten.

Solche unerwünschten Veränderungen können wiederum Auswirkungen auf Signale und Ströme haben, die über die betroffenen Stellen hinweg übertragen werden müssen. Beispielsweise kann ein entstandener Mikroriss als zusätzliche parasitäre Kapazität wirken und somit das Wechselstromübertragungsverhalten der betroffenen Signalstrecke beeinflussen, so dass die Signalübertragung gestört wird. Dies wiederum kann insbesondere auf der Empfängerseite solcher Signalübertragungen zu Fehlfunktionen führen, etwa wenn ein auf einem das Signal empfangenden Chip eine Software auf einem Prozessor abläuft, deren korrekte Funktion von einer synchronen Signalübertragung gemäß einem bestimmten Systemtakt abhängt. Auch andere Zuverlässigkeitsprobleme können als Folge der genannten unerwünschten Veränderungen auftreten, wie etwa lokale Überhitzungen, dadurch bedingte, insbesondere thermoelastische, Bauteil- oder Baugruppenverformungen, verringerte Signalübertragungs- oder Signalverarbeitungsgeschwindigkeiten, Systemparameterverschiebungen oder erhöhte Leistungsaufnahme.

Heute bekannte Ansätze zur Zuverlässigkeitsprüfung von elektronischen Systemen, insbesondere Halbleiterchips, beruhen in der Regel darauf, zu einem oder mehreren Prüfungszeitpunkten eine oder mehrere Funktionalitäten des Systems bzw. Chips nach einem definierten Testverfahren auf spezifikationsgemäße Funktion zu testen. Zu diesen bekannten Verfahren gehören insbesondere sogenannte "Boundary-Scan Testverfahren", wobei es sich um in der Regel standardisierte Verfahren zum Testen digitaler und analoger Bausteine in der Elektronik handelt. Durch die Komplexität und Kleinheit heutiger Schaltungsaufbauten wird es jedoch immer schwieriger, physisch auf bestimmte Punkte einer Schaltung zuzugreifen. Unter anderem aus diesem Grund liefern Boundary-Scan Testverfahren oftmals nicht die system- oder applikationsspezifisch notwendige Testabdeckung, insbesondere Auflösungstiefe.

Zusätzlich sind diese Testverfahren oft sehr zeitintensiv und damit kostspielig sowie für den laufenden Betrieb im Rahmen eines Selbsttests, insbesondere eines BIST (Build-in-Self-Test), im Feld ungeeignet. Build-in-Self-Test bedeutet, dass ein elektronischer Baustein eine integrierte Testschaltung besitzt, welche Testsignale erzeugt und meist auch mit vorgegebenen richtigen Antwort-Signalen vergleicht, so dass das Testresultat an eine automatisierte Testvorrichtung ATE (Automatic Test Equipment) ausgegeben werden kann.

US 2011/133753 A1 offenbart eine elektronische Vorrichtung und ein zugehöriges Verfahren, wobei die Vorrichtung eine Leiterplatte mit einem Satz von Eingangskontakten, einem Satz von Ausgangskontakten, eine elektrische Schaltung, die zwischen den Eingangskontakten und den Ausgangskontakten angeschlossen ist, und einen Controller aufweist. Das Steuergerät führt einen Echtzeittest der Leiterplatte unter Verwendung eines in die elektrische Schaltung eingeleiteten Testsignals durch, wobei die elektrische Schaltung als passives Netzwerk mit einer charakteristischen Übertragungsfunktion ausgebildet und mit mindestens zwei getrennten Teilschaltungen versehen ist, wobei die getrennten Teilschaltungen im bestückten Zustand durch Zusammenwirken mit mindestens einem von: mindestens einer Gerätekomponente und/oder Montagekomponenten elektrisch verbunden sind.

US 2017/343601 A1 offenbart ein computerimplementiertes Verfahren und ein System zur Prüfung, Charakterisierung und Diagnose integrierter Schaltungen. Das System kann ein zu prüfendes Gerät, wie z.B. eine integrierte Schaltung, enthalten, das einen adaptiven Mikrocontroller enthält. Das Verfahren umfasst das Laden eines Testprogramms zur Ausführung durch den adaptiven Mikrocontroller, wodurch der Mikrocontroller veranlasst wird, das Testprogramm auszuführen. Sobald Ergebnisse aus dem Testprogramm empfangen werden, kann das Testprogramm auf der Grundlage der Ergebnisse adaptiv modifiziert werden. Das geänderte Prüfprogramm kann erneut ausgeführt werden. Das Testprogramm kann Parameter der integrierten Schaltung verändern, die von außen nicht zugänglich sind.

DE 60 2004 007525 T2 offenbart ein System und ein Verfahren zur Bereitstellung einer eingebauten Charakterisierung eines Halbleiterbauelements. Das Bauelement ist mit einer eingebauten, integrierten Charakterisierungseinheit versehen, die eine Charakterisierung des Bauelements ohne die Notwendigkeit einer externen Testausrüstung ermöglicht.

US 6,269,326 B1 offenbart ein Testverfahren für elektronische Bauteile sowie dazu eine Vorrichtung, die Verarbeitungsmittel umfasst, die geeignet sind, eine Prüfeinrichtung zu steuern, um wiederholt mindestens einige Schritte des Verfahrens auszuführen, wobei jedes Mal die Dauer mindestens eines dieser Schritte reduziert wird, bis ein Endkriterium erfüllt ist, das die Verteilung der von der Einrichtung gemessenen elektrischen Variablen für jeden reduzierten Zeitwert berücksichtigt, und um einen neuen Zeitwert einzustellen, der höchstens gleich seinem Anfangswert ist, für den die gemessene Verteilung der elektrischen Variablen eine ausgewählte Streuungsbedingung erfüllt. Sie umfasst außerdem einen Funktionsgenerator, der in der Lage ist, eine Funktion zu liefern, die auf mindestens einen der Terme eines während einer der genannten Schritte durchgeführten Vergleichs anwendbar ist, so dass die Funktion auf eine nach der neuen Dauer durchgeführte Messung wirkt. Um risikobehaftete Lücken im Testprozess sowohl während der Herstellung als auch der Qualifikation oder des Feld-Einsatzes zu schließen und dadurch die applikationsspezifischen Zuverlässigkeitsanforderungen zu erreichen, ist bei Verwendung bekannter Testverfahren in der Regel ein sehr hoher Testaufwand schon während einer Bauteil- und Baugruppenfertigung bis hin zum fertigen Gesamtsystem (zum Beispiel Fahrzeug oder Fahrzeugsubsystem, z.B. Steuergerät) entlang der Wertschöpfungskette erforderlich. Ohne eine solche Testabsicherung schon der Zwischenprodukte ist in der Regel, soweit möglich, ein "Kompensations-Engineering" auf Systemebene (z.B. Fahrzeug oder Subsystem davon) erforderlich sind, was wiederum sehr aufwendig und kostspielig sein kann. Dieser hohe Aufwand kann im Extremfall sogar dazu führen, dass bestimmte innovative Produkte (z.B. Chips mit High Pin Count ball-grid array (BGA)-Gehäusen) erst gar nicht als Systemkomponenten ausgewählt werden, obwohl sie für manche Applikationen ansonsten besonders geeignet wären, zum Beispiel im Kontext von Systemen für hochautomatisierte oder autonome Fahrzeuge.

Es ist somit eine Aufgabe der vorliegenden Erfindung eine verbesserte Lösung zur Absicherung der Zuverlässigkeit eines elektronischen Systems anzugeben. Insbesondere wird eine Lösung angestrebt, die im Bereich der Automobiltechnik zum Einsatz kommen kann.

Diese Aufgabe wird durch ein Verfahren und eine Vorrichtung gemäß den unabhängigen Patentansprüchen gelöst. Weitere vorteilhafte Ausführungsformen sind in den Unteransprüchen sowie in der Beschreibung und den Figuren aufgezeigt.

Ein erster Aspekt der Erfindung betrifft ein, insbesondere computerimplementiertes, Verfahren zum Überwachen der Zuverlässigkeit eines elektronischen Systems. Das Verfahren weist auf: (i) Wiederholtes Messen an verschiedenen Messzeitpunkten einer Übertragungsqualität von über eine leitungsgebundene elektrische Signalübertragungsstrecke an das oder von dem elektronischen System gesendeten Signalen gemäß einem vorbestimmten Übertragungsqualitätsmaß; (ii) Vergleichen, für jeden der Messzeitpunkte, der zugehörigen gemessenen Übertragungsqualität mit einem gemäß dem Übertragungsqualitätsmaß zuvor bestimmten jeweiligen zugeordneten Referenzwert für die Übertragungsqualität; und (iii) Bestimmen eines dem jeweiligen Messzeitpunkt zugeordneten Werts eines Zuverlässigkeitsindikators in Abhängigkeit von dem Ergebnis des zugehörigen Vergleichs. Dabei wird das Übertragungsqualitätsmaß als ein Maß für die Ausdehnung eines Teilbereichs eines ein- oder mehrdimensionalen Betriebsparameterbereichs des elektronischen Systems definiert, in dem das elektronischen System gemäß einem vorbestimmten Zuverlässigkeitskriterium zuverlässig arbeitet.

Unter einem "elektronischen System" im Sinne der Erfindung ist ein ein- oder mehrkomponentiges System zu verstehen, welches zumindest ein elektronisches Bauelement als Komponente aufweist. Insbesondere sind einzelne elektronischen Bauelemente, beispielsweise eines Halbleiterchips (z.B. System-on-Chip, SOC), oder zumindest ein elektronisches Bauelemente aufweisende elektronische Systeme, wie beispielsweise einen Chipsatze oder einer eine Mehrzahl elektronischer Bauelemente aufweisende Baugruppen, jeweils elektronische Systeme im Sinne der Erfindung. Bei dem elektronischen System kann es sich insbesondere um ein System handeln, das zum Einsatz in der Fahrzeugtechnik vorgesehen ist, insbesondere als Bestandteil eines Fahrzeugs, wie etwa eines Automobils oder Kraftrads, bzw. eines Fahrzeugsubsystems, wie etwa einem Steuergerät (ECU).

Das "wiederholte Messen" kann insbesondere als kontinuierliche Messung oder als mehrfache punkt- oder zeitabschnittsweise Messung zu verschiedenen aufeinanderfolgenden diskreten Messzeitpunkten bzw. Messzeitbereichen implementiert sein.

Die leitungsgebundene elektrische Signalübertragungsstrecke kann insbesondere zwischen zwei oder mehr elektronischen Komponenten, insbesondere Halbleiterbauelementen, z.B. integrierten Schaltungen (IC) verlaufen, von denen zumindest eine Komponente selbst Teil des zu überwachenden elektronischen Systems ist. Sie kann somit insbesondere innerhalb des Systems zwischen verschiedenen seiner Systemkomponenten verlaufen. Die Signalübertragungsstrecke kann insbesondere zumindest teilweise über eine oder mehrere Leiterbahnen auf einer oder mehreren Leiterplatten (PCB) und oder Lötstellen verlaufen. Sie kann auch mittels einer unmittelbaren Kontaktierung zwischen den Komponenten, etwa mittels einer sogenannten Flip-Chip-Verbindung ausgebildet sein, bei der zwei oder mehr Chips unmittelbar aufeinander angeordnet und dabei über zumindest einen Teil ihrer Anschlusskontakte (Pins) miteinander elektrisch verbunden werden. In anderen Ausführungen kann die Übertragungsstrecke aber auch als eine Schleifenverbindung zwischen einem Ausgang und einem Eingang derselben Systemkomponente verlaufen (closed-loop). In der Übertragungsstrecke können zudem in jedem der o.g. Fälle ein oder mehrere weitere Komponenten, insbesondere elektronische Bauteile, wie etwa passive oder aktive Bauelemente oder ganze Schaltungen, z.B. ICs, als Zwischenknoten vorgesehen sein.

Die Übertragungsqualität wird gemäß dem vorbestimmten Übertragungsqualitätsmaß gemessen. Das bedeutet - in Analogie zum Messen einer Strecke mit einem Metermaß - dass die Übertragungsqualität mit dem vorbestimmten Übertragungsqualitätsmaß als im übertragenen Sinn "Maßstab" bestimmt wird. Das Übertragungsqualitätsmaß ist dabei als ein Maß für die Ausdehnung eines Teilbereichs eines ein- oder mehrdimensionalen Betriebsparameterbereichs des elektronischen Systems definiert, in dem das elektronischen System gemäß einem vorbestimmten Zuverlässigkeitskriterium zuverlässig arbeitet. Der Betriebsparameterbereich ist hier ein ein- bzw. mehrdimensionaler Wertebereich für entsprechend einen oder mehrere Betriebsparameter des Systems.

Der bzw. die Betriebsparameter können insbesondere technische Parameter sein, die eine Eigenschaft, insbesondere einen Pegel und/oder eine Phase des an oder von dem elektronischen System übertragenen Signals sein. Das Zuverlässigkeitskriterium kann auf jeden einer Mehrzahl von Arbeitspunkten des Betriebsparameterbereichs angewandt werden, um damit festzustellen, ob für diesen jeweiligen Arbeitspunkt eine ausreichende Übertragungsqualität vorliegt und das System somit an diesem Arbeitsunkt im oben genannten Sinne "zuverlässig arbeitet". Insbesondere kann das Zuverlässigkeitskriterium anhand einer Schwelle für eine Übertragungsfehlerrate, z.B. einer Bitfehlerrate (bit error rate, BER), definiert sein und etwa festlegen, dass im betrachteten Arbeitspunkt ein zuverlässiges Arbeiten vorliegt, wenn die Übertragungsfehlerrate unterhalb einer vorbestimmten Fehlerschwelle liegt, die insbesondere auch Null sein kann.

Die genannte Prüfung der auf einen bestimmten Arbeitspunkt bezogenen Übertragungsqualität anhand des Zuverlässigkeitskriteriums ist jedoch nicht zu verwechseln mit dem übergeordneten Übertragungsqualitätsmaß. Letzteres ist nämlich auf Basis einer bestimmten Ausdehnung desjenigen Teilbereichs des Betriebsparameterbereichs definiert, der durch die Arbeitspunkte mit jeweils gemäß dem Zuverlässigkeitskriterium ausreichender Übertragungsqualität bestimmt ist und diese Arbeitspunkte im Betriebsparameterbereich einschließt. Die Ausdehnung kann sich insbesondere auf das N-dimensionales "Volumen" des Teilbereichs beziehen, wobei N eine natürliche Zahl ist, die der Dimension des Betriebsparameterbereichs entspricht. Stattdessen kann die Ausdehnung sich auch auf ein "Volumen" kleinerer Dimension M < N beziehen. Beispielsweise kann die Ausdehnung für N = 3 als Größe einer zweidimensionalen Fläche oder als Länge einer eindimensionalen Strecke beziehen, die jeweils durch die Grenzen des Teilbereichs begrenzt sind. Im eindimensionalen Fall M = 1 kann die Ausdehnung somit insbesondere als ein Durchmesser des Teilbereichs definiert sein. Im Falle von N > 3 kann das zur Bestimmung der Ausdehnung des Teilbereichs betrachtete Volumen dagegen auch eine Dimension M > 3 aufweisen.

Das Verfahren gemäß dem ersten Aspekt der Erfindung ist also in der Lage, nicht nur zu einem gegebenen Messzeitpunkt festzustellen, ob sich das zu überwachende System zu diesem Zeitpunkt in einem fehlerfreien oder jedenfalls im Rahmen seiner Spezifikation unkritischen bzw. zulässigen Betriebszustand befindet. Vielmehr ist es zusätzlich in der Lage, über einen längeren Zeitraum hinweg und schon zu einer Zeit, in der das zu überwachende System noch einwandfrei funktioniert, seine Zuverlässigkeit und deren zeitliche Veränderung zu bestimmen und sogar brauchbare Voraussagen über die voraussichtlich verbleibende ausreichend sichere Restbetriebslaufzeit oder ausreichend sicher nutzbare Lebenszeit des Systems zu machen. Insbesondere können nun auch Eigenschaften von elektronischen Bauteilen bzw. elektronischen Bauelementen frühzeitig erkannt werden, die mit den bisher bekannten Testverfahren nicht oder nicht ausreichend früh vor Eintritt einer funktionalen Störung detektiert werden konnten. So können grundsätzlich insbesondere Integritäts-, Degradations- oder Alterungseffekte innerhalb (z. B. Delamination von Schichten, Elektromigration etc.) und außerhalb (z. B. Lötverbindung) dieser Elektronikbauelemente frühzeitig detektiert und diagnostiziert werden, die später zur Störung von elektrischen oder thermischen Kontakteigenschaften sowie von Signalübertragungseigenschaften führen könnten.

Zudem kann anhand des Vergleichs der zugehörigen gemessenen Übertragungsqualität mit einem gemäß dem Übertragungsqualitätsmaß zuvor bestimmten jeweiligen zugeordneten Referenzwert für die Übertragungsqualität, an jedem der Messzeitpunkte festgestellt werden, ob das System inzwischen einen Betriebszustand erreicht hat, an dem ein Eingreifen, wie etwa ein Austausch oder eine Reparatur des Systems oder von Teilen davon, vorteilhaft oder gar geboten ist, um seine Betriebssicherheit weiterhin zu gewährleisten.

Das Verfahren kann insbesondere nicht nur zur Laufzeit des zu überwachenden Systems bei seinem Einsatz im Feld, sondern auch schon im Rahmen seiner dem Einsatz vorausgehenden Herstellung und Qualifikation bzw. Endprüfung genutzt werden. So lassen sich insbesondere auch verbesserte Risikomanagement-Prozesse erreichen, welche insbesondere auch die Bereiche Entwicklung, Produktion, Qualifikation und Lieferkette miteinschließen können, und so einen in dieser Hinsicht durchgängigen Absicherungsprozess zu erreichen. So können insbesondere beim Einsatz auch modernster Halbleiter-Technologien, wie auch von anspruchsvollen Gehäusetechnologien dafür, als auch beim Einsatz passiver Elektronikbauelemente frühzeitig Risiken transparent gemacht werden, um entsprechend frühzeitig geeignete Maßnahmen entlang der Entwurfshierarchie ergreifen zu können. Ohne diese Aspekte bzw. die hieraus resultierenden Maßnahmen wäre gerade die sehr sicherheitsrelevante automobile Absicherungskette - unabhängig von der Erfüllung bestehender Standards - zumindest teilweise unterbrochen.

Nachfolgend werden bevorzugte Ausführungsformen des Verfahrens beschrieben, die jeweils, soweit dies nicht ausdrücklich ausgeschlossen wird oder technisch unmöglich ist, beliebig miteinander sowie mit den weiteren beschriebenen anderen Aspekten der Erfindung kombiniert werden können.

Gemäß einigen Ausführungsformen sind die über die Übertragungsstrecke übertragenen Signale Hochfrequenzsignale (d.h. Signale mit zumindest einem Spektralanteil im Kilohertzbereich oder höher), beispielsweise digitale Signale mit Datenübertragungsraten im GBaud-Bereich. Dies hat den Vorteil, dass etwaige vorhandene Beeinträchtigungen oder Defekte der Übertragungsstrecke, wie etwa Mikrorisse an Lötstellen oder thermoplastische Bauteilgehäuseverformungen, welche oftmals alterungs- oder beschädigungsabhängig sind und sich auf die kapazitiven Eigenschaften der Übertragungsstrecke oder deren Impedanz (und somit insbesondere auf den Imaginärteil des komplex dargestellten Signals) als entsprechende Änderung derselben und somit auch des resultierenden Frequenzspektrums von über die Übertragungsstrecke übertragenen Signalen auswirken, gut im Rahmen der wiederholten Messungen detektiert werden können.

Gemäß einigen Ausführungsformen sind die Referenzwerte für die Übertragungsqualität als konstante Werte festgelegt, so dass für sämtliche Messzeitpunkte derselbe Referenzwert gilt. In dazu alternativen Ausführungsformen kann der Referenzwerte dagegen zeitabhängig, insbesondere messzeitpunktabhängig festgelegt sein, und somit sein zeitlicher Wertverlauf beispielsweise einer erwarteten Alterungskurve des Systems angepasst sein. So lassen sich die mittels des Referenzwerts bestimmten Sicherheitsanforderungen zeitlich variabel gestalten und insbesondere mit zunehmendem Alter oder Betriebszeit des Systems zunehmend verschärfen, um stets die geforderte Betriebssicherheit sicherstellen zu können.

Gemäß einigen Ausführungsformen wird das Übertragungsqualitätsmaß
(a) im Falle eines eindimensionalen Betriebsparameterbereichs in Abhängigkeit von zumindest einem der folgenden definiert: (i) einer Ausdehnung des Teilbereichs innerhalb des Betriebsparameterbereichs; (ii) dem Verhältnis einer Ausdehnung des Teilbereichs innerhalb des Betriebsparameterbereichs zu einer spezifizierten maximalen Ausdehnung des Betriebsparameterbereichs;
(b) im Falle eines mehrdimensionalen Betriebsparameterbereichs in Abhängigkeit von zumindest einem der folgenden definiert: (i) dem Verhältnis einer zumindest zweidimensionalen Ausdehnung des Teilbereichs zur entsprechenden spezifizierten Ausdehnung des gesamten Betriebsparameterbereichs oder eines definierten Ausschnitts davon; (ii) einer Ausdehnung des Teilbereichs entlang einer durch eine ausgewählte einzelne Dimension des Betriebsparameterbereichs oder entlang einer durch eine Linearkombination von mehreren seiner Dimensionen bestimmten Ausdehnungsrichtung; (iii) dem Verhältnis einer Ausdehnung des Teilbereichs entlang einer durch eine ausgewählte einzelne Dimension oder entlang einer durch eine Linearkombination von mehreren Dimensionen des Betriebsparameterbereichs bestimmten Ausdehnungsrichtung zu einer spezifizierten maximalen Ausdehnung des Betriebsparameterbereichs entlang dieser Ausdehnungsrichtung; oder
(c) in Abhängigkeit einer für einen oder mehrere ausgewählte einzelne Arbeitspunkte innerhalb des Betriebsbereichs oder eines vorbestimmten Ausschnitts davon jeweils gemessenen und insbesondere gemäß dem vorbestimmten Zuverlässigkeitskriterium bewerteten Übertragungsqualität definiert, welche insbesondere auf Basis einer Übertragungsfehlerrate, z.B. BER, bestimmt sein kann.

Soweit in den vorgenannten Ausführungsformen die Dimension des Betriebsparameterbereichs mit derjenigen des Teilbereichs zusammenfällt, können diese Ausführungsformen vorteilhaft dazu verwendet werden, die Zuverlässigkeit des elektronischen Systems in Abhängigkeit von sämtlichen Dimensionen des Betriebsparameterbereichs zu bestimmen. Andernfalls, d. h. wenn die Dimension des Teilbereichs geringer ist, als die des Betriebsparameterbereichs, kann dies jedoch dazu genutzt werden, gezielt einzelne Aspekte der Zuverlässigkeit zu adressieren, insbesondere zu bestimmen.

Wenn beispielsweise ein zweidimensionaler Betriebsparameterbereich vorliegt, in dem ein erster Betriebsparameter einen Pegel des über die Übertragungsstrecke übertragenen Signals repräsentiert und ein zweiter Betriebsparameter eine zugehörige Phase des Signals repräsentiert, dann kann im Falle gleicher Dimensionen des Betriebsparameterbereichs und des Teilbereichs die gesamte Fläche des dann zweidimensionalen Teilbereichs zur Bestimmung des Übertragungsqualitätsmaßes herangezogen werden, welches somit sowohl von den Signalpegeln als auch den Signalphasen in den im Teilbereich liegenden Arbeitspunkten abhängt und in diesem Sinne ein umfassendes Maß darstellt. Andererseits kann im Falle einer geringeren Dimension des Teilbereichs, im vorliegenden Beispiel also eines eindimensionalen Teilbereichs, der z.B. nur die Signalphasen betrifft, gezielt der Zuverlässigkeitsaspekt bezüglich dieser Dimension (hier also z.B. der Phasentreue bzw. -varianz) gemessen und zur in diesem Sinne selektiven Bestimmung des Übertragungsqualitätsmaßes herangezogen werden.

Bei Verwendung von solchen vorgenannten Ausführungsformen, bei denen die Ausdehnung des Teilbereichs entlang einer nicht mit einer einzelnen Dimension zusammenfallenden Ausdehnungsrichtung bestimmt wird, d. h. im Falle der Verwendung der oben genannten Linearkombinationen zur Bestimmung der Ausdehnungsrichtung, können die verschiedenen an der jeweiligen Linearkombination beteiligen Dimensionen allesamt zugleich berücksichtigt werden, wobei in Abhängigkeit von der genauen Richtung der Ausdehnungsrichtung innerhalb des Betriebsparameterbereichs, d. h. in Abhängigkeit von den jeweiligen Gewichtsfaktoren der Summanden innerhalb der Linearkombination, gezielt eine beliebige gewünschte Gewichtung der einzelnen an der Linearkombination beteiligten Dimensionen eingestellt werden kann, was es insbesondere ermöglicht, spezielle von mehreren Dimensionen abhängige Fehlermuster zu detektieren.

Gemäß einiger zugehöriger Varianten der vorgenannten Ausführungsformen wird das Übertragungsqualitätsmaß zusätzlich in Abhängigkeit von zumindest einem die Lage des Teilbereichs innerhalb des Betriebsparameterbereichs charakterisierenden Parameter definiert. Auf diese Weise kann insbesondere in die Bestimmung der Zuverlässigkeit gemäß den Zulässigkeitsindikator eingehen, ob der Teilbereich innerhalb des Betriebsparameterbereichs gemäß einem definierten Bezugspunkt oder einer Bezugsrichtung symmetrisch oder asymmetrisch gelegen ist. Die Teilbereiche können somit insbesondere als Achsenabschnitte entlang einer Dimension oder als Abschnitte auf einer mittels einer der o.g. Linearkombinationen definierten anderen Ausdehnungsrichtung definiert werden. Wieder bezugnehmend auf das vorausgehen genannte Beispiel, in dem einer der Betriebsparameter und somit eine der Dimensionen des Betriebsparameterbereichs sich auf die Phase des übertragenen Signals bezieht, könnte dies beispielsweise dazu verwendet werden, festzustellen, ob der Teilbereich bezüglich positiver und negativer Phasenverschiebungen symmetrisch zu einem Nullpunkt der Phasenverschiebungen liegt, oder ob eine der beiden Phasenverschiebungsrichtungen stärker bzw. schwächer von einer Veränderung der Zuverlässigkeit betroffen ist. Unter Verwendung des o.g. Konzepts des Achsenabschnitts, könnte stattdessen auch gezielt nur die Zuverlässigkeit bzw. deren zeitliche Veränderung im Hinblick auf nur positive oder alternativ nur negative Phasenverschiebungen betrachtet werden. Auch mehrseitige Beschneidungen des Teilbereichs wären denkbar, etwa indem er allseitig oder bezüglich zumindest einer bestimmten Ausdehnungsrichtung so beschnitten wird, dass nur noch ein begrenzter Wertebereich innerhalb des auf Basis des Zuverlässigkeitskriteriums bestimmten ursprünglichen Teilbereichs betrachtet und als (neuer) Teilbereich definiert wird. So könnte man etwa im genannten Beispiel den Teilbereich auf einen bestimmten ausgewählten, innerhalb des ursprünglichen Teilbereichs gelegenen Phasenbereich entlang der Phasendimension des Betriebsparameterbereichs zuschneiden, d.h. begrenzen.

Gemäß einigen Ausführungsformen wird die Übertragungsqualität mittels des Übertragungsqualitätsmaßes in Abhängigkeit von Daten bestimmt, die ein den Betriebsbereich aufspannendes Shmoo-Diagramm sowie den Teilbereich darin repräsentieren. Dabei kann die für den jeweiligen Messzeitpunkt zu messende Übertragungsqualität insbesondere in Abhängigkeit vom Wert zumindest eines Parameters bestimmt werden, der eine bestimmte zumindest näherungsweise ermittelte Ausdehnung des Teilbereichs innerhalb des Shmoo-Diagramms repräsentiert.

Unter einem "Shmoo-Diagramm" (engl. "Shmoo plot") versteht man, insbesondere wie vorliegend in der Elektrotechnik, eine grafische Darstellung des Verhaltens einer Komponente oder eines Systems, das sich über einen Bereich von Bedingungen oder Eingängen ändert. Shmoo-Diagramme werden häufig verwendet, um die Ergebnisse der Prüfung komplexer elektronischer Systeme wie Computer oder integrierter Schaltungen wie DRAMs, ASICs oder Mikroprozessoren darzustellen. Die Darstellung zeigt insbesondere den Teilbereich der Bedingungen bzw. Arbeitspunkte innerhalb seines Betriebsparameterbereichs, unter denen das zu testende System unter Einhaltung seiner relevanten Spezifikationen zuverlässig arbeitet. Zum Beispiel können bei einer Prüfung von elektronischen Systemen in Form oder unter Beteiligung von Halbleiterspeichern Spannungen, Temperatur und Aktualisierungsraten der Halbleiterspeicher als deren Betriebsparameter über bestimmte Bereiche variiert werden, wobei jedoch nur bestimmte Arbeitspunkte, d.h. Kombinationen dieser Faktoren, einen zuverlässigen Betrieb der Vorrichtung ermöglichen. Auf unabhängigen Achsen (z.B. Spannung, Temperatur, Bildwiederholraten) aufgezeichnet, umschließt der zuverlässige Arbeitswertbereich, der hierin als "Teilbereich" bezeichnet wird, ein im vorliegenden Beispiel dreidimensionales, meist unregelmäßig geformtes Volumen.

Bei diesen Ausführungsformen kann also, beispielsweise im zweidimensionalen Fall, eine Fläche des Teilbereichs innerhalb des Shmoo-Diagramms anhand der es repräsentierenden Daten zumindest näherungsweise, etwa durch Zählung der in dem Teilbereich liegenden Arbeitspunkte, bestimmt werden. Auch die Größe des gesamten betrachteten, insbesondere spezifizierten, Betriebsparameterbereichs kann auf gleiche Weise bestimmt werden.

Gemäß einigen Ausführungsformen umfasst für jeden Messzeitunkt das jeweilige Messen der Übertragungsqualität ein Messen einer jeweiligen Übertragungsfehlerrate, die insbesondere anhand einer Bitfehlerrate (BER oder BFR) oder eines Bitfehlerverhältnisses bzw. -quotienten (BFV oder BFQ) ausgedrückt werden kann, bezüglich einer digitalen Signalübertragung über die Signalübertragungsstrecke für eine Mehrzahl von Arbeitspunkten innerhalb des spezifizierten mehrdimensionalen Betriebsparameterbereichs. Dabei wird zudem die Übertragungsqualität für den jeweiligen Messzeitpunkt auf Basis der zugehörigen so gemessenen Übertragungsfehlerraten bestimmt. Das auf einer bestimmten Ausdehnung des Teilbereichs beruhende Übertragungsqualitätsmaß kann somit insbesondere dadurch bestimmt werden, dass die entsprechende Ausdehnung des Teilbereichs auf Basis der Anzahl derjenigen Arbeitspunkte bestimmt wird, deren jeweilige Übertragungsfehlerrate unterhalb einer vorbestimmten Fehlerschwelle liegt, die insbesondere auch Null sein kann. Anstelle der Anzahl der Arbeitspunkte kann insbesondere auch das durch diese Arbeitspunkte aufgespannte und in seiner Dimension der des Teilbereichs entsprechende Teilvolumen des Betriebsparameterbereichs zur Bestimmung der Ausdehnung herangezogen werden.

Bei einigen dieser Ausführungsformen erfolgt das Vergleichen der zu einem jeweiligen Messzeitpunkt gemessenen Übertragungsqualität mit einem gemäß dem Übertragungsqualitätsmaß zuvor bestimmten zugeordneten jeweiligen Referenzwert für die Übertragungsqualität so erfolgt, dass die zu dem jeweiligen Messzeitpunkt gemessene Übertragungsqualität in Form eines Mittelwerts oder Medianwerts in den Vergleich eingeht, der sich aus einer Mittelung bzw. Medianbildung auf Basis dieser gemessenen Übertragungsqualität und zumindest einer zu einem demgegenüber früheren Messzeitpunkt gemessenen Übertragungsqualität bezüglich der Übertragungsstrecke ergibt. Dabei wurden diese Übertragungsqualitäten jeweils gemäß dem Übertragungsqualitätsmaß bestimmt. Diese Art des Vergleichs stellt eine besonders leicht, d. h. insbesondere mit geringer Komplexität, zu realisierende Möglichkeit zur Implementierung des Verfahrens dar, die insbesondere einen Glättungseffekt bezüglich kurzzeitiger Schwankungen der Übertragungsqualität aufweist und somit zur Erhöhung der Robustheit des Verfahrens gegenüber solchen, oftmals auf nur temporäre systemexterne Störungen zurückgehende Schwankungen der Messergebnisse für die Übertragungsqualität genutzt werden kann.

Bei einigen Ausführungsformen wird der jeweilige einem oder mehreren Messzeitpunkten zugeordnete Referenzwert in Abhängigkeit von zumindest einem der Betriebsparameter, insbesondere auf Basis eines zum jeweiligen Messzeitpunkt gegenwärtigen, kumulierten oder über die Vergangenheit oder zumindest einen Abschnitt davon gemittelten Werts davon, bestimmt. So kann der Referenzwert insbesondere in Abhängigkeit von der Temperatur, der Luftfeuchtigkeit, der Stromaufnahme, einer Versorgungsspannung, einem Signalpegel oder einer Signalphase des übertragenen Signals, oder einer Vibration, der das elektronische System ausgesetzt ist, bestimmt werden.

Am Beispiel der Temperatur oder der Luftfeuchtigkeit kann der Referenzwert somit insbesondere auch in Abhängigkeit von einem (voraussichtlichen) Ort oder einer geographischen Region, an dem bzw. in der sich das elektronischen Systems befindet und somit von dem dort vorherrschenden Klima festgelegt werden. Begünstigt etwa ein bestimmtes Klima Korrosion oder andere schädliche Einflüsse auf das elektronische System, so könnte der Referenzwert so festgelegt werden, dass er zu einem höheren Sicherheitsniveau bezüglich der Zulässigkeit des elektronischen Systems korrespondiert, sodass er schneller erreicht wird, als beim Betrieb des Systems in demgegenüber weniger kritischen Klimazonen. Im Falle von Fahrzeugen ist es beispielsweise denkbar, das regionale Varianten desselben Fahrzeugtyps mit verschiedenen Referenzwerten oder Referenzwertverläufen versehen werden, um den verschiedenen Regionen zugeordnete unterschiedlichen Klimabedingungen somit berücksichtigen zu können.

Auch eine zeitabhängige Festlegung des jeweiligen Referenzwerts in Abhängigkeit von kumulierten bislang aufgetretenen mechanischen oder elektrischen Belastungen des elektronischen Systems, beispielsweise durch Vibration oder elektrische Last oder eine Anzahl von aufgetretenen Aufstart(Boot)-Vorgängen oder das Alter des Systems oder einer an der Übertragung beteiligten Komponente davon, lässt sich auf diese Weise erreichen, um insgesamt die durch das Verfahren geleistete Zuverlässigkeitsüberwachung, insbesondere unter sicherheitsrelevanten Gesichtspunkten, zu optimieren.

Bei einigen Ausführungsformen weist der Betriebsparameterbereich jeweils als Dimension zumindest einen der folgenden Betriebsparameter auf: (i) einen Betriebsparameter, der einen Signalpegel eines über die Übertragungsstrecke übertragenen Signals kennzeichnet; (ii) einen Betriebsparameter, der eine Signalphase eines über die Übertragungsstrecke übertragenen Signals kennzeichnet; (iii) einen Betriebsparameter, der eine Betriebstemperatur des elektronischen Systems oder der Übertragungsstrecke kennzeichnet; (iv) einen Betriebsparameter, der einen Alterungszustand des elektronischen Systems oder der Übertragungsstrecke kennzeichnet; (v) einen Betriebsparameter, der einen oder mehrere äußere Einflüsse oder Einwirkungen, denen das elektronische System ausgesetzt ist, kennzeichnet. Solche Einflüsse oder Einwirkungen können insbesondere durch Vibration, mechanischem Schock, mechanische, elektrische oder magnetische Einwirkungen, beispielsweise durch eine in Wechselwirkung mit dem System stehende Leiterplatte oder Gehäusestruktur. Bei den Einflüssen bzw. Einwirkungen kann es sich insbesondere um eine Umgebungstemperatur, Luftfeuchtigkeit oder chemische Luftzusammensetzung oder um auf das System einwirkende Druck- oder Zugkräfte oder elektrische oder magnetische Felder handeln. Allen diesen bestimmten Betriebsparameter ist gemein, dass sie typischerweise eine ausgeprägte Korrelation mit der Zuverlässigkeit des zugehörigen elektronischen Systems aufweisen, und somit besonders als Indikatoren bzw. Messgrößen, auf deren Basis die Zuverlässigkeit des elektronischen Systems bestimmt beziehungsweise abgeschätzt werden kann, geeignet sind.

Bei einigen Ausführungsformen werden der die Referenzwerte für die Übertragungsqualität zu verschiedenen Messzeitpunkten vor der Bestimmung des Teilbereichs unter bestimmten Referenzbedingungen, beispielsweise mittels Durchfahrens einer Vielzahl von aufeinanderfolgenden vordefinierten Temperaturzyklen, ermittelt und für das nachfolgende Vergleichen mit den Ergebnissen der wiederholten Messung der Übertragungsqualität in einer Datenstruktur innerhalb einer, bevorzugt nichtflüchtigen, Speichervorrichtung vorgehalten. Insbesondere kann die Speichervorrichtung als Teil des zu überwachenden elektronischen Systems selbst vorgesehen sein, was insbesondere eine Offline-Verwendung bzw. eine entsprechend autarke Verfahrensdurchführung ermöglicht. Bei der Datenstruktur kann es sich insbesondere um eine solche handeln, die eine Wertetabelle, insbesondere eine sogenannte Lookup-Tabelle (LUT) repräsentiert. Die in der Datenstruktur abgelegten Referenzwerte können dabei insbesondere auch gemäß einem oder mehreren Betriebsparameterwerten gruppiert abgelegt sein, beispielsweise so, dass die zu einer jeweiligen bestimmten Einsatztemperatur bestimmten Referenzwerte jeweils zu einer Gruppe zusammengefasst abgelegt sind. Das zusammengefasste Ablegen kann sich dabei insbesondere auf die physikalische oder logische Adressierung in der Speichervorrichtung oder auf die softwareseitige Zugriffsmöglichkeit, z.B. im Rahmen einer Indizierung von Datenfeldern in der Datenstruktur, beziehen.

Bei einigen Ausführungsformen wird der jeweilige Wert des Zuverlässigkeitsindikators so bestimmt wird, dass er in Abhängigkeit vom Ergebnis des Vergleichs eine ausreichende Zuverlässigkeit oder eine mangelnde Zuverlässigkeit anzeigt. Der Zuverlässigkeitsindikator liefert in diesem Fall unmittelbar eine Aussage über die auf den letzten Messzeitpunkt bezogenen Zuverlässigkeit des Systems.

Bei einigen dieser Ausführungsformen erfolgt die Bestimmung des jeweiligen Werts des Zuverlässigkeitsindikators anhand eines Prüfkriteriums, welches dynamisch in Abhängigkeit von einer Mehrzahl von vorausgehend bestimmten Werten des Zuverlässigkeitsindikators oder gegebenenfalls des resultierenden Zuverlässigkeitsindikators angepasst wird. So kann beispielsweise das Prüfkriterium dynamisch verschärft werden, wenn auf Basis der jeweils vorausgehend bestimmten Werte des Zuverlässigkeitsindikators bzw. des resultierenden Zuverlässigkeitsindikators eine zunehmende Alterung des überwachten Systems oder unerwartete Schwankungen dieser Werte auftreten, die auf einen sich ausbildenden Defekt hinweisen könnten.

Dabei kann das dynamische Anpassen des Prüfkriteriums insbesondere im Rahmen eines maschinellen Lernens auf Basis der vorausgehend bestimmten Werte des Zuverlässigkeitsindikators oder gegebenenfalls des resultierenden Zuverlässigkeitsindikators erfolgen. So lässt sich nicht nur eine Automatisierung der dynamischen Bestimmung des Prüfkriteriums, sondern auch eine verbesserte Leistungsfähigkeit dieser Anpassung im Hinblick auf eine frühe und verlässlichere Erkennung sich ausbildender Störungen oder Defekte, insbesondere bei komplexen zeitlichen Verläufen des Werts des Zuverlässigkeitsindikators, erreichen.

Bei einigen dieser Ausführungsformen wird der Wert des Zuverlässigkeitsindikators in Abhängigkeit von einer bei dem Vergleich ermittelten Abweichung der jeweiligen gemäß dem Übertragungsqualitätsmaß gemessenen Übertragungsqualität von dem zugehörigen jeweiligen Referenzwert anhand eines der folgenden Prüfkriterien bestimmt: (i) falls die anhand des Vergleichs ermittelte Abweichung einen vorbestimmten festen Wert für die Mindestabweichung nicht unterschreitet, wird der Wert des Zuverlässigkeitsindikator so gesetzt, dass er eine ausreichende Zuverlässigkeit und andernfalls eine mangelnde Zuverlässigkeit anzeigt; (ii) falls die anhand des Vergleichs ermittelte Abweichung einen in Abhängigkeit vom Messzeitpunkt festgelegten Wert für die Mindestabweichung nicht unterschreitet, wird der Wert des Zuverlässigkeitsindikator so gesetzt, dass er eine ausreichende Zuverlässigkeit und andernfalls eine mangelnde Zuverlässigkeit anzeigt; (iii) falls der jeweilige Messzeitpunkt vor dem Zeitpunkt des Erreichens eines vorbestimmten Alterungszustands des elektronischen Systems liegt, wird der Wert des Zuverlässigkeitsindikator so gesetzt, dass er eine ausreichende Zuverlässigkeit und andernfalls eine mangelnde Zuverlässigkeit anzeigt. Insbesondere kann der Wert des Zuverlässigkeitsindikators in Abhängigkeit von einem absoluten Wert, einem auf eine Referenzabweichung bezogenen, oder einem über einen Zeitbereich gemittelten Wert der jeweiligen Abweichung und somit auf einfache Weise bestimmt werden.

Gemäß Prüfkriterium (i) kann somit eine zeitlich konstante Zuverlässigkeitsschwelle eingesetzt werden, die sich auf einen entweder ebenfalls zeitlich invarianten Referenzwert oder aber auf einen zeitlich veränderlichen, insbesondere messzeitpunktabhängigen, Referenzwert bezieht. Somit lassen sich insgesamt auf Basis des Referenzwertverlaufs und der festen Zuverlässigkeitsschwelle insbesondere eine feststehende Wertschwelle oder aber eine mit dem zeitlich variablen Referenzwert mitwandernde und somit ebenfalls zeitlich variable Wertschwelle als Zuverlässigkeitsgrenze etablieren. Gemäß Prüfkriterium (ii) ist stattdessen oder kumulativ die Zuverlässigkeitsschwelle selbst variabel, was im Zusammenspiel mit einem zeitlich konstanten oder aber veränderlichen Referenzwert ebenfalls zur Definition einer zeitlich variablen Wertschwelle als Zuverlässigkeitsgrenze genutzt werden kann. Die Prüfkriterien (i) und (ii) können somit insbesondere dann vorteilhaft eingesetzt werden, wenn es darum geht, um den zeitlichen Verlauf des Referenzwerts einen über die Zeit bandförmig verlaufenden Wertebereich festzulegen, der zu einer mangelnden Zuverlässigkeit korrespondiert, während Zuverlässigkeitswerte außerhalb des Bandes zu einer ausreichenden Zuverlässigkeit, d. h. zu einem gemäß dem Zulässigkeitskriterium zuverlässig arbeitenden System, korrespondieren.

Prüfkriterium (iii) definiert dagegen eine harte Altersgrenze bezüglich eines vorbestimmten Alterungszustands des elektronischen Systems. Dabei kann der Alterungszustand auf verschiedene Weise definiert sein, beispielsweise auf Basis des absoluten Alters, einer aufgelaufenen Gesamtbetriebszeit, eine Anzahl von erfolgten Aufstarts oder einem beliebigen vorbestimmten anderen alterungsabhängigen Eigenschaft oder Betriebshistorie des Systems oder einer an der Signalübertragung beteiligten Komponente davon.

Bei einigen Ausführungsformen ist in der Übertragungsstrecke zumindest ein elektronisches Bauteil angeordnet und die Ermittlung der Übertragungsqualität zum jeweiligen Messzeitpunkt erfolgt in Abhängigkeit von der Art des zumindest einen Bauelements. So lassen sich auch aufgrund des Vorhandenseins von zumindest einem Bauelement komplexere Übertragungsstrecken zur Überwachung der Zuverlässigkeit des elektronischen Systems nutzen. Dies kann insbesondere dann hilfreich sein, wenn eine Überwachung auf Basis einer bauteilfreien Übertragungsstrecke nicht möglich ist, oder wenn es sowieso gewünscht ist eine solche komplexere Übertragungsstrecke als Ganzes zur Überwachung der Zuverlässigkeit heranzuziehen und somit einen erweiterten Bereich möglicher Fehlerursachen zu berücksichtigen. Als solche in der Übertragungsstrecke befindliche Bauelemente kommen insbesondere passive Bauelemente, wie etwa Kondensatoren und Widerstände (auch sogenannte "Null Ω"- Widerstände mit vernachlässigbarem ohmschen, d. h. realteilbezogenen, Widerstandswert), oder auch aktive Bauelemente oder solche enthaltende Schaltungen (beispielsweise ICs) infrage. Die Referenzwerte werden dementsprechend spezifisch für die Art und Anordnung des bzw. der Bauelemente in der Übertragungsstrecke festgelegt.

Bei einigen Ausführungsformen wird das Verfahrens des Weiteren zur Bestimmung eines jeweiligen weiteren Zuverlässigkeitsindikators für die Messpunkte auf Basis einer wiederholten Messung der Übertragungsqualität gemäß dem vorbestimmten Übertragungsqualitätsmaß von über eine zweite, von der ersten verschiedenen, Signalübertragungsstrecke an das oder von dem elektronischen System gesendeten Signalen angewendet. Zudem wird ein resultierender Zuverlässigkeitsindikator zum jeweiligen Messzeitpunkt für das elektronische System oder zumindest eine der Übertragungsstrecken in Abhängigkeit von dem für die erste Übertragungsstrecke für den jeweiligen Messzeitpunkt bestimmten Zuverlässigkeitsindikator und dem für diesen jeweiligen Messzeitpunkt für die zweite Übertragungsstrecke bestimmten weiteren Zuverlässigkeitsindikator bestimmt.

Auf diese Weise ist es möglich, die Überwachung der Zuverlässigkeit des elektronischen Systems auf Basis einer Zuverlässigkeitsmessung von zwei oder mehr verschiedenen Übertragungsstrecken vorzunehmen und somit die Robustheit des Verfahrens insgesamt zu erhöhen. Insbesondere ist es damit in vielen Fällen möglich, systeminterne Defekte oder Störungen, welche ihre Ursache in der Übertragungsstrecke oder einer oder mehreren Komponenten des Systems selbst haben, von solchen Störungen zu unterscheiden, die eine externe Ursache haben und beispielsweise mittels elektromagnetischer Ankopplung von Störsignalen, insbesondere nur temporär, auftreten. Eine solche Unterscheidung ist insbesondere dann möglich, wenn der Zuverlässigkeitsverlauf bezüglich der zwei oder mehr verschiedene Übertragungsstrecken deutlich unterschiedlich verläuft, sodass davon ausgegangen werden kann, dass eine Untermenge der Übertragungsstrecken einer externen Störung unterliegt, während dies bei der durch die anderen Übertragungsstrecke gebildeten Untermenge der Übertragungsstrecken nicht der Fall ist.

Bei einigen Ausführungsformen weist das Verfahren des Weiteren ein Auslösen einer Aktion des elektronischen Systems selbst oder einer darauf einwirkenden Aktion einer anderen Entität auf, wenn gemäß dem ermittelten Wert des Zuverlässigkeitsindikators oder gegebenenfalls des resultierenden Zuverlässigkeitsindikators eine ausreichende Zuverlässigkeit des elektronischen Systems nicht mehr gegeben ist. Beispielsweise könnte ein Störungsmeldung des Systems ausgelöst werden oder dieses durch sich selbst oder eine andere Entität, wie etwa eine Stromversorgungseinrichtung oder eine in Kommunikationsverbindung mit dem System stehende Steuereinheit, in einen sicheren Betriebsmodus überführt werden. Somit kann auf ein verfahrensgemäß erkanntes Zuverlässigkeitsproblem angemessen und frühzeitig reagiert werden, um spätere durch mangelnde Zuverlässigkeit bedingte Schäden vorab vermeiden zu können. Beispielsweise kann so rechtzeitig eine Wartung oder ein Ersatz des elektronischen Systems, der Übertragungsstrecke(n) oder einzelner Bestandteile oder Komponenten davon erfolgen.

Ein zweiter Aspekt der Erfindung betrifft eine Vorrichtung zum Überwachen der Zuverlässigkeit eines elektronischen Systems, wobei die Vorrichtung eingerichtet ist, das Verfahren gemäß dem ersten Aspekt der Erfindung auszuführen. Das System kann insbesondere prozessorbasiert ausgebildet und somit in der Lage sein, das Verfahren mit Hilfe eines es ganz oder teilweise implementierenden Computerprogramms auszuführen. Die Vorrichtung kann insbesondere ein Steuergerät für ein Fahrzeug, wie etwa ein Automobil oder Kraftrad, sein.

Ein dritter Aspekt der Erfindung betrifft ein Computerprogramm, welches Instruktionen enthält, die bei ihrer Ausführung auf einem oder mehreren einer Vorrichtung nach dem zweiten Aspekt der Erfindung zugeordneten Prozessoren, die Vorrichtung veranlassen, das Verfahren gemäß dem ersten Aspekt der Erfindung auszuführen.

Das Computerprogramm kann insbesondere auf einem nichtflüchtigen Datenträger gespeichert sein. Bevorzugt ist dies ein Datenträger in Form eines optischen Datenträgers oder eines Flashspeichermoduls. Dies kann vorteilhaft sein, wenn das Computerprogramm als solches unabhängig von einer Prozessorplattform gehandelt werden soll, auf der das ein bzw. die mehreren Programme auszuführen sind. In einer anderen Implementierung kann das Computerprogramm als eine Datei auf einer Datenverarbeitungseinheit, insbesondere auf einem Server vorliegen, und über eine Datenverbindung, beispielsweise das Internet oder eine dedizierte Datenverbindung, wie etwa ein proprietäres oder lokales Netzwerk, herunterladbar sein. Zudem kann das Computerprogramm eine Mehrzahl von zusammenwirkenden einzelnen Programmodulen aufweisen.

Die Vorrichtung nach dem zweiten Aspekt der Erfindung kann entsprechend einen Programmspeicher aufweisen, in dem das Computerprogramm abgelegt ist. Alternativ kann die Vorrichtung auch eingerichtet sein, über eine Kommunikationsverbindung auf ein extern, beispielsweise auf einem oder mehreren Servern oder anderen Datenverarbeitungseinheiten verfügbares Computerprogramm zuzugreifen, insbesondere um mit diesem Daten auszutauschen, die während des Ablaufs des Verfahrens bzw. Computerprogramms Verwendung finden oder Ausgaben des Computerprogramms darstellen.

Die in Bezug auf den ersten Aspekt der Erfindung erläuterten Merkmale und Vorteile gelten entsprechend auch für die weiteren Aspekte der Erfindung.

Weitere Vorteile, Merkmale und Anwendungsmöglichkeiten der vorliegenden Erfindung ergeben sich aus der nachfolgenden detaillierten Beschreibung im Zusammenhang mit den Figuren.

Dabei zeigt:
**Fig.** 1 schematisch eine beispielhafte Ausführungsform eines zu überwachenden elektronischen Systems, welches zugleich eine beispielhafte Vorrichtung zur Ausführung des erfindungsgemäßen Verfahrens darstellt;
**Fig. 2** schematisch ein Flussdiagramm zur Veranschaulichung einer bevorzugten Ausführungsform des erfindungsgemäßen Verfahrens;
**Fig. 3** ein beispielhaftes Shmoo-Diagramm über einem mehrdimensionalen Betriebsbereich des elektronischen Systems;
**Fig. 4** einen beispielhaften Kennlinienverlauf für die gemäß dem Übertragungsqualitätsmaß aus einer Ausdehnung des Teilbereichs bestimmte Übertragungsqualität des Systems sowie zwei beispielhafte Kennlinienverläufe für den Referenzwert; und
**Fig. 5** drei beispielhaften Kennlinienverlauf für die gemäß dem Übertragungsqualitätsmaß aus einer Ausdehnung des Teilbereichs bestimmte Übertragungsqualität des Systems für drei verschiedene Werte des Betriebsparameters "Temperatur".

In den Figuren werden durchgängig dieselben Bezugszeichen für dieselben oder einander entsprechenden Elemente der Erfindung verwendet.

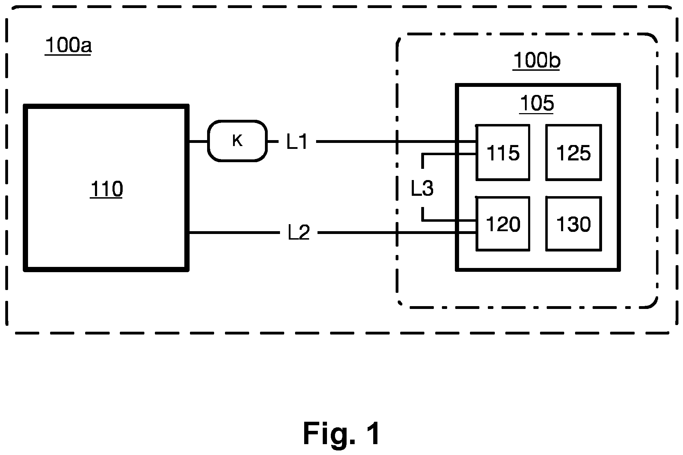

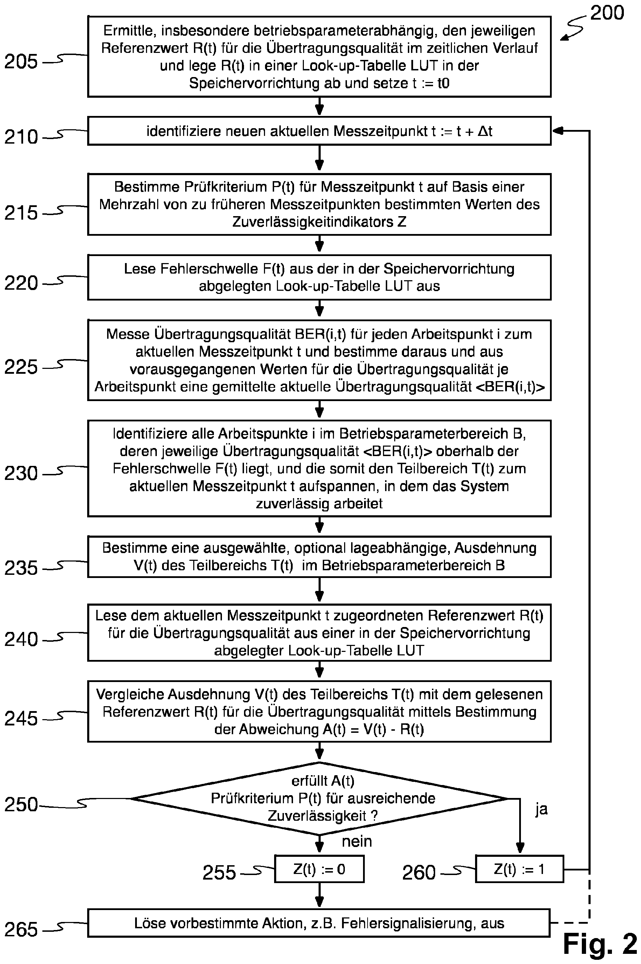

Das in **Fig. 1** illustrierte zu überwachende System 100a, weist eine erste integrierte Halbleiterschaltung 105 sowie eine zweite integrierte Halbleiterschaltung 110 als Bauelemente beziehungsweise Systemkomponenten auf. Im vorliegenden Beispiel sind die beiden Halbleiterschaltungen 105 und 110 über zwei verschiedene elektrische leitungsgebundene Signalübertragungsstrecken L1 und L2 miteinander verbunden und können darüber elektrische Signale, insbesondere digitale Signale, austauschen. Die Halbleiterschaltung 105 weist dafür entsprechende Kommunikationsschnittstellen 115 beziehungsweise 120 auf. Ähnliches kann entsprechend für die Halbleiterschaltung 110 gelten (nicht dargestellt). Die Kommunikationsschnittstellen 115 und 120, sowie ihre jeweiligen Gegenseiten am anderen Ende der jeweiligen Übertragungsstrecke können insbesondere gemäß einer bekannten Kommunikationstechnologie, beispielsweise gemäß dem PCI Express (PCIe) Standard, ausgebildet sein. In der Signalübertragungsstrecke L1 ist zusätzlich eine weitere elektronische Komponente K, beispielsweise ein Widerstand oder eine Kapazität als Bauelement vorgesehen. Zusätzlich sind die beiden Kommunikationsschnittstellen 115 und 120 über eine Signalübertragung Schleife L3 miteinander verbunden, über die ebenfalls Signale, insbesondere digitale Signale, übertragen werden können. Die Halbleiterschaltung 105 weist es weiteren einen Prozessor 125 sowie eine Speichervorrichtung 130 auf, in der insbesondere ein auf dem Prozessor 125 ablauffähiges Computerprogramm zur Implementierung des erfindungsgemäßen Verfahrens (beispielsweise gemäß Fig. 2) sowie dazu benötigten Daten, wie etwa eine Lookup-Tabelle LUT abgelegt sein können.

Sämtliche Komponenten des Systems befinden sich auf einer (nicht dargestellten) Schaltungsplatine und sind darauf mechanisch und elektrisch mittels entsprechender Lötstellen an zugehörigen Leiterbahnen der Schaltungsplatine verbunden.

Anstelle der Gesamtanordnung 100a kann alternativ auch nur die Halbleiterschaltung 105 als zu überwachendes System 100b betrachtet werden. Das System 100a bzw. 100b ist somit in der Lage, sich anhand des erfindungsgemäßen Verfahrens im Sinne eines Selbsttests selbst bezüglich seiner Zuverlässigkeit überwachen, so dass es zugleich eine mögliche Ausführungsform der erfindungsgemäßen Vorrichtung darstellt.

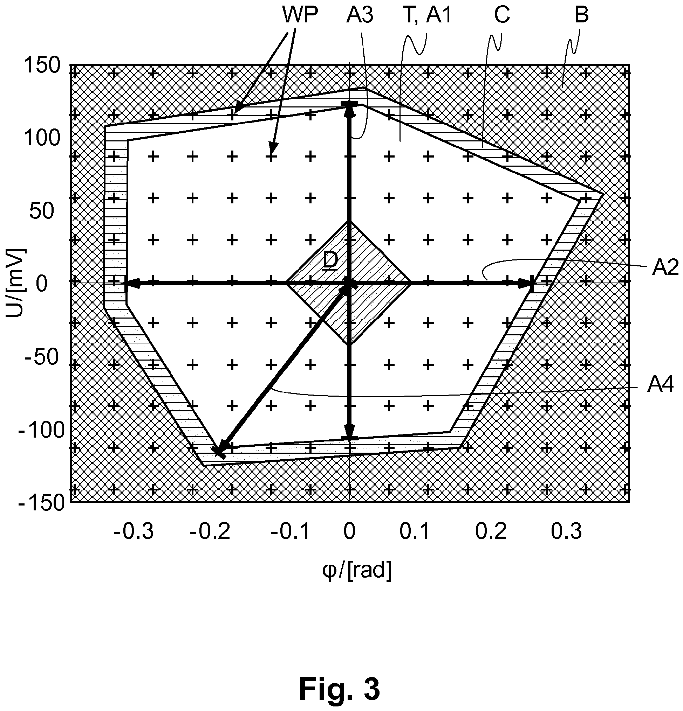

Im Folgenden wird nun unter Bezugnahme auf die **Figuren 2 bis 5** eine beispielhafte Ausführungsform des in **Fig. 2** illustrierten erfindungsgemäßen Verfahrens 200, das insbesondere zur Überwachung eines Systems 100a bzw. 100b gemäß Fig. 1 eingesetzt werden kann, erläutert. Dementsprechend wird hier beispielhaft auf ein System gemäß Fig. 1 Bezug genommen. Der Betriebsparameterbereich B ist in diesem Beispiel zweidimensional mit dem durch eine Signalspannung U ausgedrückten Signalpegel und der zugehörigen Signalphase Φ als Dimensionen definiert (vgl. **Fig. 3**). Als Übertragungsstrecke kann jede der Übertragungsstrecken L1, L2 oder L3 zur Zuverlässigkeitsüberwachung herangezogen werden, optional auch mehr als eine davon, insbesondere in Kombination.

Der Ablauf des Verfahrens 200 kann in drei aufeinanderfolgende Phasen eingeteilt werden, wobei eine erste Phase eine möglicherweise nur einmalig durchlaufene Vorbereitungsphase darstellt, welche einen Vorbereitungsprozess bzw. -schritt 205 enthält (die Begriffe "Prozess" und "Schritt" werden hier als gleichbedeutend verwendet, und können sich je nach Zusammenhang auf einen einzelne Maßnahme oder eine Mehrzahl von zu eine Prozess zusammengefassten Maßnahmen beziehen).

Im Rahmen dieses Vorbereitungsprozesses 205 werden die Werte für einen zeitabhängigen Referenzwert R(t) für die gemäß einem definierten Übertragungsqualitätsmaß bestimmte Übertragungsqualität definiert und in einer Lookup-Tabelle LUT in der Speichervorrichtung 130 der Halbleiterschaltung 105 abgelegt. Die Bestimmung des zeitlichen Verlaufs des Referenzwerts und somit der genannten Werte, kann insbesondere so erfolgen, dass die Fehleranfälligkeit des Systems 100a bzw. 100b geprüft wird, indem die nachfolgend beschriebene zweite Phase zwei des Verfahrens unter wohldefinierten Testbedingungen durchgeführt wird, um einen Datensatz zu generieren, der eine initiale Version des in **Fig. 3** dargestellten Shmoo-Diagramms für einem initialen Zeitpunkt t1 im Lebenslauf des Systems repräsentiert. Aus diesem Datensatz wird dann, wie nachfolgend für spätere Messzeitpunkte im Einzelnen beschrieben werden wird, ein Wert V(t1) für eine initiale Zuverlässigkeit bestimmt.

Zugleich ist die Form, Größe und Lage eines minimalen, für einen ordnungsgemäßen Betrieb des Systems 100a bzw. 100b erforderlichen Teilbereichs D des Betriebsbereichs B bekannt (vgl. **Fig. 3**), beispielsweise aus der Spezifikation des Systems oder vorbekannten insbesondere applikationsspezifischen Leistungsanforderungen. Gleiches gilt für einen Übergangbereich C, der zwischen dem Teilbereich T und dem äußeren Teil des Betriebsparameterbereichs B, in dem das System aufgrund einer zu hohen statistischen Häufigkeit für das Auftreten von Übertragungsfehlern nicht zuverlässig arbeitet oder sogar ausfällt, liegt. Im Übergangbereich C ist die statistische Häufigkeit für das Auftreten von Übertragungsfehlern und einen etwaigen dadurch bedingten Systemausfall zwar höher als im Teilbereich T aber geringer als im äußeren Teil des Betriebsparameterbereichs B, so dass hier gegebenenfalls unter Nutzung ausreichender Fehlerkorrekturmaßnahmen noch eine ausreichend zuverlässige Übertragung erreichbar wäre. Es wäre also denkbar, den Teilbereich T um den Übergangsbereich C zu erweitern, wenn solche ausreichenden Fehlerkorrekturmaßnahmen genutzt würden. Im Folgenden wird jedoch eine solche Erweiterung nicht betrachtet.

Der Referenzwert R(t1) wird nun so gewählt, dass er im Shmoo-Diagramm einer geschlossenen Kurve bzw. Fläche entsprechen würde, die zum einen den minimalen Teilbereich vollständig umhüllt und zum anderen vollständig im Teilbereich T verläuft, der durch die Arbeitspunkte im Betriebsparameterbereich B des Systems aufgespannt wird, an denen das System zum Zeitpunkt t1 fehlerfrei und zuverlässig arbeitet.

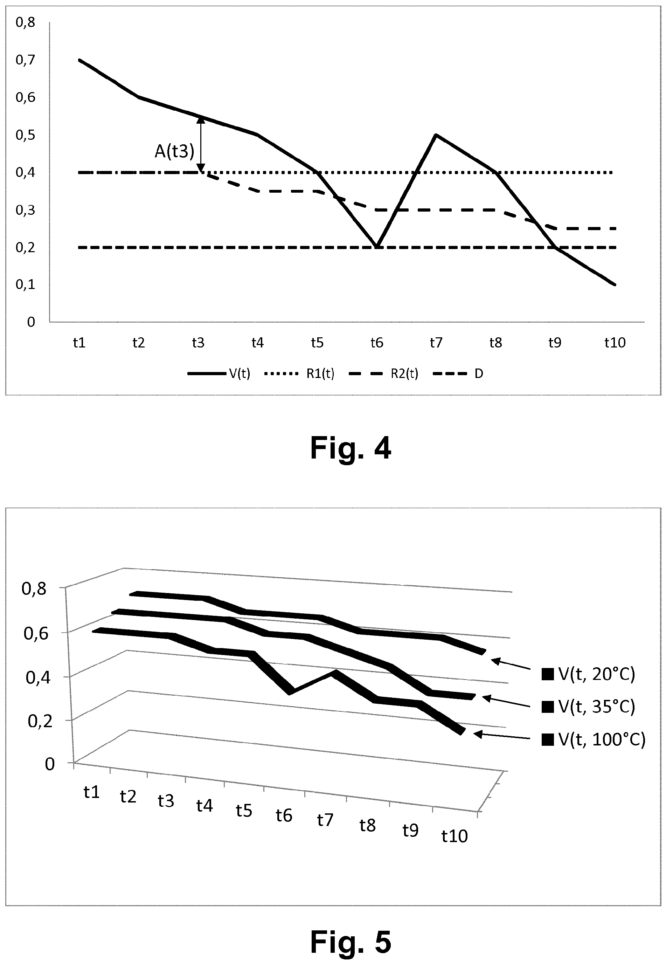

Ausgehend von diesem Referenzwert R(t1) kann sodann ein gewünschter zeitlicher Verlauf R(t) festgelegt werden. Insbesondere kann der Referenzwert R auch als Konstante definiert werden (vgl. **Fig. 4****:** R1(t) = R1 = konst.). Stattdessen kann der Referenzwert R(t) auch zeitlich veränderlich festgelegt werden, insbesondere so, dass seine Repräsentation im Schmoo-Diagramm einem zunehmenden, optional auch gestuften, Zusammenziehen um den minimalen Teilbereich D entspricht, ohne diesen jedoch zu unterschreiten (vgl. **Fig. 4****:** R2(t), D). Die Festlegung des Referenzwertes kann insbesondere in Abhängigkeit von einem oder mehreren ausgewählten Betriebsparametern, wie beispielsweise einer Umgebungstemperatur erfolgen, insbesondere dann, wenn zu erwarten ist, dass die späteren zeitlichen Verläufe der gemäß dem Übertragungsqualitätsmaß gemessenen Übertragungsqualität V(t) von diesem bzw. diesen ausgewählten Betriebsparametern abhängen, wie dies am Beispiel einer Temperaturabhängigkeit in **Fig. 5** illustriert ist.

Nach dem Schritt bzw. Prozess 205, der insbesondere noch werkseitig durchgeführt werden kann, beginnt die zweite Phase des Verfahrens, in dem die eigentliche Überwachung des Systems, beispielsweise während seines Einsatzes im Feld, stattfindet. In einem Schritt 210 wird dazu zunächst ein neuer aktueller Messzeitpunkt t festgelegt, was insbesondere mittels Inkrementierens (t:= t + Δt) eines vorausgegangenen Messzeitpunkts erfolgen kann. Der Wert t kann insbesondere als Zeitindex verwendet werden, um verschiedene aufeinanderfolgende, jedoch nicht notwendigerweise äquidistante, Messzeitpunkte zu indizieren. Im vorliegenden Beispiel wird jedoch auf die genannte Inkrementierung zurückgegriffen, wodurch sich äquidistante Messzeitpunkte t1, t2, ..., t10 ergeben.

In einem weiteren Schritt 215 wird für den aktuellen Messzeitpunkt t ein zugeordnetes Prüfkriterium P(t) bestimmt. Soweit vorhanden, erfolgt dies auf Basis einer Mehrzahl von zu früheren Messzeitpunkten bestimmen Werten des in jedem schleifenförmigen Durchlauf der zweiten Phase des Verfahrens in den Schritten 255 beziehungsweise 260 bestimmten Zuverlässigkeitsindikators Z(t). Sodann wird in einem Schritt 220 aus der in der Speichervorrichtung 130 abgelegten Lookup Tabelle LUT eine dem aktuellen Messzeitpunkt zugeordnete Fehlerschwelle F(t) ausgelesen. Diese Fehlerschwelle kann insbesondere als fester Wert beziehungsweise Werteverlauf *ab initio* in der Lookup-Tabelle LUT festgelegt sein, oder aber ebenfalls erst im Rahmen von Schritt 205 der Vorbereitungsphase, insbesondere auf Basis der Ergebnisse der dort zu den verschiedenen Messpunkten WP durchgeführten Übertragungsqualitätsmessungen, festgelegt und in die Lookup-Tabelle LUT geschrieben werden.

Nun kann in einem Schritt 225 für den aktuellen Messzeitpunkt t die eigentliche Messung der Zuverlässigkeit des Systems 100a bzw. 100b beginnen. Dazu wird im Schritt 225 das System nacheinander in jedem Arbeitspunkt aus einer Menge vorbestimmten Arbeitspunkten WP (vgl. **Fig. 3**) im Betriebsparameterbereich jedes Systems, die hier zum Zwecke der Illustration mit dem Index i indiziert werden, getestet und dabei eine entsprechende zugeordnete Übertragungsqualität in Form einer Bitfehlerrate BER(i, t) gemessen. Optional, kann wie in **Fig. 2** illustriert, daraus sowie aus in früheren Durchläufen der zweiten Phase des Verfahrens zu diesem jeweiligen Arbeitspunkt i bestimmten Bitfehlerraten eine gemittelte "aktuelle" Übertragungsqualität, ausgedrückt durch die gemittelte Bitfehlerrate (BER(i, t)), berechnet werden.

Nun werden in einem weiteren Schritt 230 alle Arbeitspunkte i im Betriebsparameterbereich B identifiziert, deren jeweilige aktuelle gemittelte Übertragungsqualität (BER(i, t)) oberhalb der dem aktuellen Messzeitpunkt t zugeordneten Fehlerschwelle F(t) liegt. Diese Arbeitspunkte i spannen somit den aktuellen Teilbereich T(t) des Betriebsparameterbereichs B auf, in denen das System 100a bzw. 100b, zuverlässig arbeitet.

Auf Basis dieser ermittelten Arbeitspunkte wird nun im Schritt 235 eine ausgewählte Ausdehnung V(t) des Teilbereichs T(t) als Maß für die Übertragungsqualität zu Messzeitpunkt t bestimmt. Dementsprechend ist das genannte Übertragungsqualitätsmaß durch die ausgewählte Art der Ausdehnung definiert. In **Fig. 3** sind vier verschiedene Übertragungsqualitätsmaße entsprechend vier verschiedenen Arten der Ausdehnung illustriert. Ein erstes Übertragungsqualitätsmaß A1 kann als Ausdehnungsmaß definiert sein, welches die zweidimensionale Ausdehnung, d.h. die Fläche, des Teilbereichs T (t) zumindest näherungsweise misst. Dies kann insbesondere auf Basis der absoluten Anzahl oder der auf eine Gesamtzahl von Arbeitsproben im Betriebsbereich B bezogenen relativen Anzahl der im Teilbereich T(t) liegenden Arbeitspunkte WP bzw. i erfolgen. Ein zweites Übertragungsqualitätsmaß A2 kann dagegen als Maß einer eindimensionalen Ausdehnung des hier zweidimensionalen Teilbereichs T(t) entlang der Phasendimension Φ definiert sein. Analog kann ein drittes Übertragungsqualitätsmaß A3 als Maß einer eindimensionalen Ausdehnung des Teilbereichs T(t) entlang der Pegeldimension U definiert sein. Ein ebenso beispielhaftes viertes Übertragungsqualitätsmaß A4 kann als Maß einer eindimensionalen Ausdehnung des Teilbereichs T(t) entlang einer durch eine Linearkombination der beiden Dimensionen Φ und U (genauer von entlang dieser Dimensionen gerichteten Vektoren) definierten und somit schräg durch den Teilbereich T(t) verlaufenden Ausdehnungsrichtung definiert sein. Die jeweilige eindimensionale Ausdehnung kann dabei insbesondere wie bei den Maßen A2 und A3 illustriert zwischen den gegenüberliegenden äußeren Grenzen des Teilbereichs T(t) verlaufen, oder aber, wie beim Maß A4 illustriert, von einem ausgewählten Punkt, insbesondere von einem Koordinatenursprung, im Teilbereich T(t) ausgehend nur am anderen Ende durch eine solchen Grenze uns somit lageabhängig definiert sein.

Das Übertragungsqualitätsmaß kann insbesondere auch als relatives Maß definiert sein. Dies lässt sich insbesondere dadurch erreichen, dass die bestimmte Ausdehnung des Teilbereichs T(t) etwa (i) auf die entsprechende Gesamtausdehnung des Betriebsparameterbereichs B (vgl. **Figuren 4 und 5****)** oder (ii) auf die entsprechende ursprüngliche Ausdehnung des Teilbereichs T (t) zum initialen Zeitpunkt t1 ins Verhältnis gesetzt wird.

Sodann wird in einem Schritt 240 der dem aktuellen Messzeitpunkt t zugeordnete Referenzwert R(t) aus der Lookup-Tabelle LUT der Speichervorrichtung 130 ausgelesen und in einem weiteren Schritt 245 mittels Differenzbildung ein Vergleich der bestimmten Ausdehnung V(t) des Teilbereichs T (t) dem gelesenen Referenzwert R(t) durchgeführt. Die dabei bestimmte Differenz A(t) = V (t) - R(t) stellt eine Abweichung der Ausdehnung V(t) von dem Referenzwert R(t) dar (vgl. Fig. 4), die als Maß für die verbleibende Zuverlässigkeit des Systems 100a beziehungsweise 100b genutzt werden kann. Dazu wird diese Abweichung A(t) in einem Schritt 250 gemäß dem dem aktuellen Messzeitpunkt t zugeordneten Prüfkriterium P(t) geprüft. Das Prüfkriterium kann dabei insbesondere so definiert sein, dass es eine Mindestschwelle für die Abweichung A(t) definiert, sodass oberhalb dieser Mindestschwelle liegende Werte für die Abweichung A(t) zu einer ausreichenden Zuverlässigkeit, darunterliegende Werte jedoch für eine mangelnde Zuverlässigkeit stehen.

Entsprechend dem Ergebnis der Prüfung wird sodann im Falle einer mangelnden Zuverlässigkeit (250 - nein) im Schritt 255 beziehungsweise im Falle einer ausreichenden Zuverlässigkeit (250 - ja) im Schritt 260 der Wert eines Zuverlässigkeitsindikators Z(t) auf einen das Prüfungsergebnisses anzeigenden Wert, beispielsweise auf einen entsprechend festgelegten Bool'schen Wert "0" bzw. "1", gesetzt.

Bei (in Fig. 2 nicht explizit dargestellter) optionaler Verwendung von zwei oder mehr der Übertragungsstrecken L1 bis L3 im Rahmen des Verfahrens, kann dessen Robustheit insbesondere noch dadurch gesteigert werden, dass die vorgenannten Schritte jeweils für jede der beteiligten Übertragungsstrecken durchgeführt und ein resultierender Zuverlässigkeitsindikator zum jeweiligen Messzeitpunkt für das elektronische System als Ganzes oder zumindest eine der beteiligten Übertragungsstrecken in Abhängigkeit von dem für die Übertragungsstrecke(n) der ersten Untermenge für den jeweiligen Messzeitpunkt bestimmten Zuverlässigkeitsindikatoren und dem für diesen jeweiligen Messzeitpunkt für die Übertragungsstrecke(n) der zweiten Untergruppe bestimmten weiteren Zuverlässigkeitsindikatoren bestimmt. Die Bestimmung des resultierenden Zuverlässigkeitsindikators kann inbesondere auf Basis eines Vergleichs, einer Korrelationsprüfung oder einer Ähnlichkeitsprüfung mittels eines Ähnlichkeitsmaßes erfolgen.

Insbesondere ist es damit in vielen Fällen möglich, systeminterne Defekte oder Störungen, welche ihre Ursache in einer Übertragungsstrecke oder einer oder mehreren Komponenten des Systems selbst haben, von solchen Störungen zu unterscheiden, die eine externe Ursache haben und beispielsweise mittels elektromagnetischer Ankopplung von Störsignalen, insbesondere nur temporär, auftreten. Eine solche Unterscheidung ist insbesondere dann möglich, wenn der Zuverlässigkeitsverlauf bezüglich der zwei oder mehr verschiedene Übertragungsstrecken deutlich unterschiedlich verläuft, sodass davon ausgegangen werden kann, dass eine erste Untermenge der Übertragungsstrecken einer externen Störung unterliegt, während dies bei der durch die anderen Übertragungsstrecke gebildeten zweiten Untermenge der Übertragungsstrecken nicht der Fall ist.

Im Falle von Schritt 260 wird sodann unmittelbar zum Schritt 210 zurückverzweigt, während im Falle von Schritt 255 davor noch der Schritt 265 folgt, in dem eine vorbestimmte Aktion, beispielsweise eine Fehlersignalisierung, ausgelöst wird.

Einige weitere Ausführungsvarianten der Erfindung werden noch im Folgenden beschrieben:
Mittels Verwendung von Kommunikationsschnittstellen und korrespondierender Protokolle können über die am Verfahren beteiligte(n) Übertragungsstrecke(n) insbesondere Datenpakete zwischen Chipsätzen übertragen werden und somit diese System bezüglich von Auswirkungen der materialtechnischen Alterung unter automobilen Lasten überwacht werden.

Ferner kann gemäß einem Ausführungsbeispiel die Look-up-Tabelle bereits während der Baugruppenfertigung in einem Referenz-Modul, beispielsweise mittels eines Programmierschritts in einer als NVM oder e-Fuse ausgebildeten Speichervorrichtung, auf der Baugruppe hinterlegt werden.

In einem weiteren Ausführungsbeispiel kann die Bestimmung der Look-Up Tabelle Signal-Pegel, -phasen oder temperatur- und alterungsabhängige BER-Erwartungswerte enthalten, die erfahrungsbasiert auf Basis des Baugruppen-Betriebskonzepts festgelegt werden, insbesondere mittels einer statistischen Versuchsplanung (DoE) - "Shmoo Diagram".

Die vorliegende Lösung ist unter anderem anwendbar auf Steuergeräte, Sensoren, sowie Module. Die Anwendung des erfindungsgemäßen Verfahrens und der erfindungsgemäßen Vorrichtung kann überall dort erfolgen, wo komplexe oder spezielle Funktionen über Halbleiter-/Elektronikprodukte zum Einsatz kommen.

Abhängig von der jeweiligen Schnittstellenspezifikation (z.B. PCIe Gen1/2, eSATA, USB) für die an der Signalübertragung beteiligten Kommunikationsschnittstellen existieren für die zu übertrageden Signale spezifizierte Varianzbereiche für die Signalpegel und -phasen. Während der DoE werden Signalarbeitspunkte (Pegel, Phase, Temperatur, unterschiedliche Voralterung der Aufbau- und Verbindungstechnik) im spezifizierten Varianzbereich eingestellt und wiederholt ein BERT durchgeführt. Resultierende Shmoo-Augendiagramme korrelieren zu den Arbeitspunkten - Spezifikations- und Eingriffsgrenzen (Referenzwert bzw. -wertverläufe) können so abgeleitet werden.

Exemplarisch wird hier zur weiteren Erläuterung der Erfindung und der damit erreichbaren Vorteile die Schnittstelle "PCIe" herangezogen. PCI Express ("Peripheral Component Interconnect Express", abgekürzt PCIe oder PCI-E) ist ein Standard zur Verbindung von Peripheriegeräten mit dem Chipsatz eines Hauptprozessors und bietet eine hohe Datenübertragungsrate pro Pin. Das PCI-Express-Protokoll enthält ein sehr robustes Verbindungsintegritätsschema, weist jedoch einige Zuverlässigkeitsbeschränkungen auf, die nicht sofort offensichtlich sind. Jedes Anwendungspaket enthält eine zyklische Redundanzprüfung (link-level cyclic redundancy check - LCRC) auf Verbindungsebene, die sofort nach Empfang verifiziert wird. Ein Bestätigt/Nicht Bestätigt (ACK / NAK) - Mechanismus behandelt die nahtlose Neuübertragung von fehlerhaften Paketen und enthält Zeitüberschreitungen, um zu gewährleisten, dass unterbrochene Verbindungen nicht unbemerkt bleiben.

Eine mögliche Einschränkung ist jedoch, dass der LCRC nur die Daten schützen kann, die der PCI Express-Schnittstellenlogik tatsächlich präsentiert werden - er bietet jedoch keine Möglichkeit zu bestätigen, dass die Daten tatsächlich korrekt sind. Zusätzlich kann die erneute Übertragung von fehlerhaften Paketen aufgrund von fehlender Bestätigung. (Not-Acknowledged/ NAK) Signalintegritätsprobleme in der physikalischen Verbindung verbergen, da die Anwendungssoftware und sogar die Hardware der oberen Schicht weniger wahrscheinlich über die erneuten Übertragungen informiert sind. Ob aufgrund eines grundlegenden Problems, das bei der Design- / Herstellungszeit auftritt, oder aufgrund von Alterung, werden somit alle bis auf die schwerwiegendsten PCI Express Link-Fehler für Software weitgehend unsichtbar sein.

Somit liegt ein vorteilhafter Bereich für erfindungsgemäß erreichbare Verbesserungen bei PCIe in der Nachverfolgung der Zuverlässigkeit aus der Perspektive der erstmaligen fehlerfreien Übertragung. Wenn beispielsweise jedes Paket drei Versuche zur erfolgreichen Zustellung benötigt, kann die Verbindung im Sinne zwar einer korrekten Datenlieferung zuverlässig sein, jedoch nicht im Sinne fehlerfreier Übertragungen. Lange Erfahrung mit PCI-Express hat gezeigt, dass Kanäle mit schlechter Qualität der Hauptverursacher für Probleme darstellen. Mittels der erfindungsgemäßen Lösung kann jedoch eine sich verschlechternde Zuverlässigkeit der PCIe-Übertragung und somit des beteiligten elektronischen Systems bereits frühzeitig detektiert werden, und das zu einem Zeitpunkt, an dem noch keinerlei funktionale Störungen auftreten und somit auf herkömmlichen Wege die sich anbahnende Zuverlässigkeitsverschlechterung noch nicht detektiert werden könnte.

Insgesamt ergeben sich unter anderem auch folgende erfindungsgemäße Vorteile: Es kann die kostenintensive Sicherstellung der funktionalen Sicherheit moderner Baugruppen und anderer elektonischer System deutlich verbessert werden.

Insbesondere auch in bezüglich Zuverlässigkeit besonders anspruchsvollen Applikationen, wie etwa in der Automobiltechnik oder der Flugzeugtechnik, kann der tatsächlich in Produkten eingesetzte Innovationsgrad korrespondierender Produkte erhöht werden, da ein zusätzlicher Überwachungs- und damit Steuerungsanteil erfindungsgemäß umgesetzt werden kann, der zuvor nicht existierte. So können auch zum gegebenen Zeitpunkt hochinnovative Produkte eingesetzt werden können, ohne die Zuverlässigkeitsanforderungen zu verletzen.

Ferner wird eine Alternative zu Redundanzkonzepten in Bezug auf Kosten, Gewicht, und Energie bereitgestellt.

Während vorausgehend wenigstens eine beispielhafte Ausführungsform beschrieben wurde, ist zu bemerken, dass eine große Anzahl von Variationen dazu existiert. Es ist dabei auch zu beachten, dass die beschriebenen beispielhaften Ausführungsformen nur nichtlimitierende Beispiele darstellen, und es nicht beabsichtigt ist, dadurch den Umfang, die Anwendbarkeit oder die Konfiguration der hier beschriebenen Vorrichtungen und Verfahren zu beschränken. Vielmehr wird die vorausgehende Beschreibung dem Fachmann eine Anleitung zur Implementierung mindestens einer beispielhaften Ausführungsform liefern, wobei sich versteht, dass verschiedene Änderungen in der Funktionsweise und der Anordnung der in einer beispielhaften Ausführungsform beschriebenen Elemente vorgenommen werden können, ohne dass dabei von dem in den angehängten Ansprüchen jeweils festgelegten Gegenstand abgewichen wird.

### BEZUGSZEICHENLISTE

- 100a, b: elektronisches System
- 105: erste Halbleiterschaltung, zugleich erfindungsgemäße Vorrichtung
- 110: zweite Halbleiterschaltung
- 115, 120: Kommunikationsschnittstellen
- 125: Prozessor
- 130: Speichervorrichtung
- 200: beispielhafte Ausführungsform des Verfahrens
- 202-265: Verfahrensschritte des Verfahrens 200

- A, A1, A4: verschiedene Ausdehnungen des Teilbereichs T
- B: Betriebsparameterbereich
- BER: Bitfehlerrate
- C: Übergangbereich
- D: minimaler Arbeitsbereich für ordnungsgemäßen Betrieb
- F: Fehlerschwelle
- i: Index zur Indizierung der Arbeitspunkte WP
- K: elektronische Komponente
- L1,...,L3: Übertragungsstrecken
- LUT: Look-up-Tabelle
- P: Prüfkriterium
- R: Referenzwert
- T: Teilbereich
- t1,...,t10: verschiedene Messzeitpunkte
- t: Index zur Indizierung der Messzeitpunkte
- U: Signalpegel
- Φ: Signalphase
- V: Übertragungsqualität
- WP: Arbeitspunkt(e) im Betriebsparameterbereich
- Z: Zuverlässigkeitsindikator

## Patentansprüche

1. Verfahren (200) zum Überwachen der Zuverlässigkeit eines elektronischen Systems (100a; 100b), aufweisend:
Wiederholtes Messen (225) an verschiedenen Messzeitpunkten (t) einer Übertragungsqualität (V) von über eine leitungsgebundene elektrische Signalübertragungsstrecke (L1) an das oder von dem elektronischen System gesendeten Signalen gemäß einem vorbestimmten Übertragungsqualitätsmaß;
Vergleichen (245), für jeden der Messzeitpunkte, der zugehörigen gemessenen Übertragungsqualität (V) mit einem gemäß dem Übertragungsqualitätsmaß zuvor bestimmten jeweiligen zugeordneten Referenzwert (R) für die Übertragungsqualität; **gekennzeichnet durch**
Bestimmen (255, 260) eines dem jeweiligen Messzeitpunkt zugeordneten Werts eines Zuverlässigkeitsindikators (Z) in Abhängigkeit von dem Ergebnis des für diesen Messzeitpunkt ausgeführten Vergleichs;
wobei das Übertragungsqualitätsmaß als ein Maß für die Ausdehnung eines Teilbereichs (T) eines ein- oder mehrdimensionalen Betriebsparameterbereichs (B) des elektronischen Systems definiert wird, in dem das elektronischen System gemäß einem vorbestimmten Zuverlässigkeitskriterium (P) zuverlässig arbeitet.

2. Verfahren nach Anspruch 1, wobei das Übertragungsqualitätsmaß
(a) im Falle eines eindimensionalen Betriebsparameterbereichs (B) in Abhängigkeit von zumindest einem der folgenden definiert wird:
- einer Ausdehnung (A1; A2; A3; A4) des Teilbereichs (T) innerhalb des Betriebsparameterbereichs;
- dem Verhältnis einer Ausdehnung (A1; A2; A3; A4) des Teilbereichs (T) innerhalb des Betriebsparameterbereichs zu einer spezifizierten maximalen Ausdehnung des Betriebsparameterbereichs;
(b) im Falle eines mehrdimensionalen Betriebsparameterbereichs in Abhängigkeit von zumindest einem der folgenden definiert wird:
- dem Verhältnis einer zumindest zweidimensionalen Ausdehnung (A1) des Teilbereichs zur entsprechenden spezifizierten Ausdehnung des gesamten Betriebsparameterbereichs oder eines definierten Ausschnitts davon;
- einer Ausdehnung (A2; A3; A4) des Teilbereichs entlang einer durch eine ausgewählte einzelne Dimension des Betriebsparameterbereichs oder entlang einer durch eine Linearkombination von mehreren seiner Dimensionen bestimmten Ausdehnungsrichtung;
- dem Verhältnis einer Ausdehnung (A2; A3; A4) des Teilbereichs entlang einer durch eine ausgewählte einzelne Dimension oder entlang einer durch eine Linearkombination von mehreren Dimensionen des Betriebsparameterbereichs bestimmten Ausdehnungsrichtung zu einer spezifizierten maximalen Ausdehnung des Betriebsparameterbereichs entlang dieser Ausdehnungsrichtung; oder
(c) in Abhängigkeit einer für einen oder mehrere ausgewählte einzelne Arbeitspunkte innerhalb des Betriebsbereichs oder eines vorbestimmten Ausschnitts davon jeweils gemessenen und gemäß dem vorbestimmten Zuverlässigkeitskriterium bewerteten Übertragungsqualität definiert wird.

3. Verfahren nach Anspruch 2, wobei das Übertragungsqualitätsmaß zusätzlich in Abhängigkeit von zumindest einem die Lage des Teilbereichs innerhalb des Betriebsparameterbereichs charakterisierenden Parameter definiert wird.

4. Verfahren nach einem der vorausgehenden Ansprüche, wobei die Übertragungsqualität mittels des Übertragungsqualitätsmaßes in Abhängigkeit von Daten bestimmt wird, die ein den Betriebsbereich aufspannendes Shmoo-Diagramm sowie den Teilbereich darin repräsentieren.

5. Verfahren nach Anspruch 4, wobei die für den jeweiligen Messzeitpunkt (t) zu messende Übertragungsqualität (V) in Abhängigkeit vom Wert zumindest eines Parameters bestimmt wird, der eine bestimmte zumindest näherungsweise ermittelte Ausdehnung (A1, ..., A4) des Teilbereichs innerhalb des Shmoo-Diagramms repräsentiert.

6. Verfahren nach einem der vorausgehenden Ansprüche, wobei:
für jeden Messzeitunkt (t) das jeweilige Messen der Übertragungsqualität ein Messen einer jeweiligen Übertragungsfehlerrate bezüglich einer digitalen Signalübertragung über die Signalübertragungsstrecke (L1) für eine Mehrzahl von Arbeitspunkten (WP) innerhalb des spezifizierten mehrdimensionalen Betriebsparameterbereichs umfasst; und
die Übertragungsqualität für den jeweiligen Messzeitpunkt auf Basis der zugehörigen so gemessenen Übertragungsfehlerraten (BER) bestimmt wird.

7. Verfahren nach Anspruch 6, wobei das Vergleichen (245) der zu einem jeweiligen Messzeitpunkt gemessenen Übertragungsqualität mit einem gemäß dem Übertragungsqualitätsmaß zuvor bestimmten zugeordneten jeweiligen Referenzwert für die Übertragungsqualität so erfolgt, dass die zu dem jeweiligen Messzeitpunkt gemessene Übertragungsqualität in Form eines Mittelwerts oder Medianwerts in den Vergleich eingeht, der sich aus einer Mittelung (225) bzw. Medianbildung auf Basis dieser gemessenen Übertragungsqualität und zumindest einer zu einem demgegenüber früheren Messzeitpunkt gemessenen Übertragungsqualität bezüglich der Übertragungsstrecke ergibt, wobei diese Übertragungsqualitäten (V) jeweils gemäß dem Übertragungsqualitätsmaß bestimmt wurden.

8. Verfahren nach einem der vorausgehenden Ansprüche, wobei der jeweilige einem oder mehreren Messzeitpunkten zugeordnete Referenzwert (R) in Abhängigkeit von zumindest einem der Betriebsparameter bestimmt wird.

9. Verfahren nach einem der vorausgehenden Ansprüche, wobei der Betriebsparameterbereich jeweils als Dimension zumindest einen der folgenden Betriebsparameter aufweist:
- einen Betriebsparameter, der einen Signalpegel (U) eines über die Übertragungsstrecke übertragenen Signals kennzeichnet;
- einen Betriebsparameter, der eine Signalphase (Φ) eines über die Übertragungsstrecke übertragenen Signals kennzeichnet;
- eine Betriebsparameter, der eine Betriebstemperatur des elektronischen Systems oder der Übertragungsstrecke kennzeichnet;
- einen Betriebsparameter, der einen Alterungszustand des elektronischen Systems oder der Übertragungsstrecke kennzeichnet;
- einen Betriebsparameter, der einen oder mehrere äußere Einflüsse oder Einwirkungen, denen das elektronische System ausgesetzt ist, kennzeichnet.

10. Verfahren nach einem der vorausgehenden Ansprüche, wobei die Referenzwerte (R) für die Übertragungsqualität zu verschiedenen Messzeitpunkten (t) vor der Bestimmung des Teilbereichs (T) unter bestimmten Referenzbedingungen ermittelt und für das nachfolgende Vergleichen mit den Ergebnissen der wiederholten Messung der Übertragungsqualität in einer Datenstruktur innerhalb einer, Speichervorrichtung (130) vorgehalten werden.

11. Verfahren nach einem der vorausgehenden Ansprüche, wobei der jeweilige Wert des Zuverlässigkeitsindikators (Z) so bestimmt wird, dass er in Abhängigkeit vom Ergebnis des Vergleichs eine ausreichende Zuverlässigkeit oder eine mangelnde Zuverlässigkeit anzeigt.

12. Verfahren nach Anspruch 11, wobei die Bestimmung des jeweiligen Werts des Zuverlässigkeitsindikators anhand eines Prüfkriteriums (P) erfolgt, welches dynamisch in Abhängigkeit von einer Mehrzahl von vorausgehend bestimmten Werten des Zuverlässigkeitsindikators oder gegebenenfalls des resultierenden Zuverlässigkeitsindikators angepasst wird.

13. Verfahren nach Anspruch 12, wobei das dynamische Anpassen des Prüfkriteriums (P) im Rahmen eines maschinellen Lernens auf Basis der vorausgehend bestimmten Werte des Zuverlässigkeitsindikators oder gegebenenfalls des resultierenden Zuverlässigkeitsindikators erfolgt.

14. Verfahren nach einem der Ansprüche 11 bis 13, wobei der Wert des Zuverlässigkeitsindikators (Z) in Abhängigkeit von einer bei dem Vergleich ermittelten Abweichung (A) der jeweiligen gemäß dem Übertragungsqualitätsmaß gemessenen Übertragungsqualität (V) von dem zugehörigen jeweiligen Referenzwert (R) anhand eines der folgenden Prüfkriterien (P) bestimmt wird:
- falls die ermittelte Abweichung einen vorbestimmten festen Wert für die Mindestabweichung nicht unterschreitet, wird der Wert des Zuverlässigkeitsindikator so gesetzt, dass er eine ausreichende Zuverlässigkeit und andernfalls eine mangelnde Zuverlässigkeit anzeigt;
- falls die ermittelte Abweichung einen in Abhängigkeit vom Messzeitpunkt festgelegten Wert für die Mindestabweichung nicht unterschreitet, wird der Wert des Zuverlässigkeitsindikator so gesetzt, dass er eine ausreichende Zuverlässigkeit und andernfalls eine mangelnde Zuverlässigkeit anzeigt;
- falls der jeweilige Messzeitpunkt vor dem Zeitpunkt des Erreichens eines vorbestimmten Alterungszustands des elektronischen Systems liegt, wird der Wert des Zuverlässigkeitsindikator so gesetzt, dass er eine ausreichende Zuverlässigkeit und andernfalls eine mangelnde Zuverlässigkeit anzeigt.

15. Verfahren nach einem der vorausgehenden Ansprüche, wobei:
in der Übertragungsstrecke (L1) zumindest ein elektronisches Bauteil (K) angeordnet ist; und;
die Ermittlung der Übertragungsqualität zum jeweiligen Messzeitpunkt in Abhängigkeit von der Art des zumindest einen Bauelements erfolgt.

16. Verfahren nach einem der vorausgehenden Ansprüche, des Weiteren aufweisend:
Anwenden des Verfahrens gemäß einem der vorausgehenden Ansprüche zur Bestimmung eines jeweiligen weiteren Zuverlässigkeitsindikators für die Messpunkte auf Basis einer wiederholten Messung der Übertragungsqualität gemäß dem vorbestimmten Übertragungsqualitätsmaß von über eine zweite, von der ersten verschiedenen, Signalübertragungsstrecke (L2; L3) an das oder von dem elektronischen System gesendeten Signalen; und
Bestimmen eines resultierenden Zuverlässigkeitsindikators zum jeweiligen Messzeitpunkt für das elektronische System oder zumindest eine der Übertragungsstrecken in Abhängigkeit von dem für die erste Übertragungsstrecke für den jeweiligen Messzeitpunkt bestimmten Zuverlässigkeitsindikator und dem für diesen jeweiligen Messzeitpunkt für die zweite Übertragungsstrecke bestimmten weiteren Zuverlässigkeitsindikator.

17. Verfahren nach einem der vorausgehenden Ansprüche, des Weiteren aufweisend:
Auslösen (265) einer Aktion des elektronischen Systems selbst oder einer darauf einwirkenden Aktion einer anderen Entität, wenn (250) gemäß dem ermittelten Wert des Zuverlässigkeitsindikators oder gegebenenfalls des resultierenden Zuverlässigkeitsindikators eine ausreichende Zuverlässigkeit des elektronischen Systems nicht mehr gegeben ist.

18. Vorrichtung (105) zum Überwachen der Zuverlässigkeit eines elektronischen Systems (100a, 100b), wobei die Vorrichtung eingerichtet ist, das Verfahren (200) gemäß einem der vorausgehenden Ansprüche auszuführen.

19. Computerprogramm, welches Instruktionen enthält, die bei ihrer Ausführung auf einem oder mehreren einer Vorrichtung (105) nach Anspruch 18 zugeordneten Prozessoren (125), die Vorrichtung (105) veranlassen, das Verfahren (200)gemäß einem der Ansprüche 1 bis 17 auszuführen.

## Claims

1. A method (200) for monitoring the reliability of an electronic system (100a; 100b), comprising:
repeatedly measuring (225), at different measurement times (t) and according to a predetermined transmission quality measure, a transmission quality (V) of signals transmitted to or from the electronic system over a wired electrical signal transmission path (L1);
comparing (245), for each of the measurement times, the associated measured transmission quality (V) with a respective associated transmission quality reference value (R) previously determined according to the transmission quality measure;
**characterized by**
determining (255, 260) a value of a reliability indicator (Z) associated with the respective measurement time in dependence on the result of the comparison associated with this measurement time;
wherein the transmission quality measure is defined as a measure of the extent of a subrange (T) of a one- or multi-dimensional operating parameter range (B) of the electronic system in which, according to a predetermined reliability criterion (P), the electronic system operates reliably.

2. The method according to claim 1, wherein the transmission quality measure is defined
(a) in the case of a one-dimensional operating parameter range (B) as a function of at least one of the following:
- an extent (A1; A2; A3; A4) of the subrange (T) within the operating parameter range;
- the ratio of an extent (A1; A2; A3; A4) of the subrange (T) within the operating parameter range to a specified maximum extent of the operating parameter range;
(b) in the case of a multidimensional operating parameter range, as a function of at least one of the following:
- the ratio of an at least two-dimensional extent (A1) of the subrange to the corresponding specified extent of the entire operating parameter range or a defined section thereof;
- an extent (A2; A3; A4) of the sub-range along an extension direction determined by a selected single dimension of the operating parameter range or along an extension direction determined by a linear combination of a plurality of its dimensions;
- the ratio of an extent (A2; A3; A4) of the subrange along an extension direction determined by a selected single dimension or along an extension direction determined by a linear combination of multiple dimensions of the operating parameter range to a specified maximum extent of the operating parameter range along that extension direction; or
(c) as a function of a transmission quality measured for one or more selected individual operating points within the operating range or within a predetermined section thereof and in each case evaluated in accordance with the predetermined reliability criterion.

3. The method according to claim 2, wherein the transmission quality measure is additionally defined as a function of at least one parameter characterizing the location of the subrange within the operating parameter range.

4. The method according to any one of the preceding claims, wherein the transmission quality is determined by means of the transmission quality measure as a function of data representing a shmoo diagram spanning the operating range and the subrange therein.

5. The method according to claim 4, wherein the transmission quality (V) to be measured for the respective measurement time (t) is determined as a function of the value of at least one parameter representing a certain at least approximately determined extent (A1, ..., A4) of the subrange within the Shmoo diagram.

6. The method according to any one of the preceding claims, wherein:
for each measurement time T(t), the respective measurement of the transmission quality comprises measuring a respective transmission error rate with respect to a digital signal transmission over the signal transmission path (L1) for a plurality of operating points (WP) within the specified multi-dimensional operating parameter range; and
the transmission quality for the respective measurement time is determined on the basis of the associated transmission error rates (BER) thus measured.

7. The method according to claim 6, wherein the comparison (245) of the transmission quality measured at a respective measurement time with an assigned respective reference value for the transmission quality determined beforehand in accordance with the transmission quality measure is performed in such a way that the transmission quality measured at the respective measurement time is included in the comparison in the form of a mean value or median value which results from an averaging (225) or median formation on the basis of this measured transmission quality and at least one transmission quality (V) measured at an earlier measurement time with respect to the transmission path, these transmission qualities (V) having been determined in each case in accordance with the transmission quality measure.

8. The method according to any one of the preceding claims, wherein the respective reference value (R) associated with one or more measurement times is determined as a function of at least one of the operating parameters.

9. The method according to any one of the preceding claims, wherein the operating parameter range has, each as a dimension, at least one of the following operating parameters:
- an operating parameter characterizing a signal level (U) of a signal transmitted via the transmission path;
- an operating parameter characterizing a signal phase (Φ) of a signal transmitted via the transmission path;
- an operating parameter characterizing an operating temperature of the electronic system or the transmission path;
- an operating parameter characterizing an aging condition of the electronic system or the transmission path;
- an operating parameter that identifies one or more external influences or impacts to which the electronic system is exposed.

10. The method according to any one of the preceding claims, wherein the reference values (R) for the transmission quality are determined at different measurement times (t) prior to the determination of the subrange (T) under specific reference conditions and are stored in a data structure within a memory device (130) for subsequent comparison with the results of the repeated measurement of the transmission quality.

11. The method according to any one of the preceding claims, wherein the respective value of the reliability indicator (Z) is determined to indicate sufficient reliability or lack of reliability depending on the result of the comparison.

12. The method according to claim 11, wherein the determination of the respective value of the reliability indicator is performed on the basis of a test criterion (P) which is dynamically adapted depending on a plurality of previously determined values of the reliability indicator or, as the case may be, of the resulting reliability indicator.

13. The method according to claim 12, wherein the dynamic adaptation of the test criterion (P) is performed in the context of machine learning on the basis of the previously determined values of the reliability indicator or, as the case may be, the resulting reliability indicator.

14. The method according to any one of claims 11 to 13, wherein the value of the reliability indicator (Z) is determined as a function of a deviation (A), determined during the comparison, of the respective transmission quality (V) measured according to the transmission quality measure from the associated respective reference value (R) based on one of the following test criteria (P):
- if the determined deviation does not fall below a predetermined fixed value for the minimum deviation, the value of the reliability indicator is set to indicate sufficient reliability and otherwise a lack of reliability;
- if the determined deviation does not fall below a value for the minimum deviation defined as a function of the measurement time, the value of the reliability indicator is set to indicate sufficient reliability and otherwise lack of reliability;
- if the respective measurement time is before the time of reaching a predetermined state of aging of the electronic system, the value of the reliability indicator is set to indicate sufficient reliability and otherwise lack of reliability.

15. The method according to any one of the preceding claims, wherein:
at least one electronic component (K) is arranged in the transmission path (L1); and;
the determination of the transmission quality at the respective measurement time is carried out depending on the type of the at least one component.

16. The method according to any one of the preceding claims, further comprising:
applying the method according to any one of the preceding claims to determine a respective further reliability indicator for the measurement times based on a repeated measurement of the transmission quality according to the predetermined transmission quality measure of signals transmitted to or from the electronic system via a second signal transmission path (L2; L3) different from the first signal transmission path; and
determining a resulting reliability indicator at the respective measurement time for the electronic system or at least one of the transmission paths as a function of the reliability indicator determined for the first transmission path for the respective measurement time and the further reliability indicator determined for this respective measurement time for the second transmission path.

17. The method according to any one of the preceding claims, further comprising:
triggering (265) an action of the electronic system itself or an action of another entity acting thereon, when (250) according to the determined value of the reliability indicator or, as the case may be, the resulting reliability indicator, the electronic system is no longer sufficiently reliable.

18. An apparatus (105) for monitoring the reliability of an electronic system (100a, 100b), the apparatus being configured to perform the method (200) according to any one of the preceding claims.

19. A computer program comprising instructions that, when executed on one or more processors (125) associated with an apparatus (105) according to claim 18, cause the apparatus (105) to execute the method (200) according to any one of claims 1 to 17.

## Revendications

1. Procédé (200) pour la surveillance de la fiabilité d'un système électronique (100a ; 100b), présentant :
la mesure (225) répétée à des moments de mesure (t) différents d'une qualité de transmission (V) de signaux envoyés par l'intermédiaire d'une ligne de transmission de signaux électrique (L1) filaire au ou à partir du système électronique selon une mesure de qualité de transmission prédéfinie ;
la comparaison (245), pour chacun des moments de mesure, de la qualité de transmission (V) mesurée associée à une valeur de référence (R) pour la qualité de transmission associée respective préalablement déterminée selon la mesure de qualité de transmission ; **caractérisé par**
la détermination (255, 260) d'une valeur d'un indicateur de fiabilité (Z) associée au moment de mesure respectif en fonction du résultat de la comparaison exécutée pour ce moment de mesure ;
dans lequel la grandeur de qualité de transmission est définie en tant que grandeur de l'étendue d'une plage partielle (T) d'une plage de paramètres de fonctionnement (B) monodimensionnelle ou multidimensionnelle du système électronique, dans lequel le système électronique fonctionne de manière fiable selon un critère de fiabilité (P) prédéfini.

2. Procédé selon la revendication 1, dans lequel la grandeur de qualité de transmission
(a) dans le cas d'une plage de paramètres de fonctionnement monodimensionnelle (B) est définie en fonction d'au moins un de ce qui suit :
- une étendue (A1 ; A2 ; A3 ; A4) de la plage partielle (T) à l'intérieur de la plage de paramètres de fonctionnement ;
- le rapport d'une étendue (A1 ; A2 ; A3 ; A4) de la plage partielle (T) à l'intérieur de la plage de paramètres de fonctionnement sur une étendue maximale spécifiée de la plage de paramètres de fonctionnement ;
(b) dans le cas d'une plage de paramètres de fonctionnement multidimensionnelle est définie en fonction d'au moins un de ce qui suit :
- le rapport d'une étendue (A1) au moins bidimensionnelle de la plage partielle sur l'étendue spécifiée correspondante de la plage de paramètres de fonctionnement totale ou d'une partie définie de celle-ci ;
- une étendue (A2 ; A3 ; A4) de la plage partielle le long d'une direction d'étendue déterminée par une dimension individuelle sélectionnée de la plage de paramètres de fonctionnement ou le long d'une direction d'étendue déterminée par une combinaison linéaire de plusieurs de ses dimensions ;
- le rapport d'une étendue (A2 ; A3 ; A4) de la plage partielle le long d'une direction d'étendue déterminée par une dimension individuelle sélectionnée ou le long d'une direction d'étendue déterminée par une combinaison linéaire de plusieurs dimensions de la plage de paramètres de fonctionnement sur une étendue maximale spécifiée de la plage de paramètres de fonctionnement le long de cette direction d'étendue ; ou
(c) est définie en fonction d'une qualité de transmission mesurée respectivement pour un ou plusieurs points de travail individuels sélectionnés à l'intérieur de la plage de fonctionnement ou d'une partie prédéfinie de celle-ci et évaluée selon le critère de fiabilité prédéfini.

3. Procédé selon la revendication 2, dans lequel la grandeur de qualité de transmission est définie en plus en fonction d'au moins un paramètre caractérisant la position de la plage partielle à l'intérieur de la plage de paramètres de fonctionnement.

4. Procédé selon l'une quelconque des revendications précédentes, dans lequel la qualité de transmission est déterminée au moyen de la grandeur de qualité de transmission en fonction de données qui représentent un diagramme des zones de fonctionnement d'un circuit couvrant la plage de fonctionnement ainsi que la plage partielle dans celle-ci.

5. Procédé selon la revendication 4, dans lequel la qualité de transmission (V) à mesurer pour le moment (t) respectif est déterminée en fonction de la valeur d'au moins un paramètre, qui représente une certaine étendue (A1, ..., A4) au moins approximativement établie de la plage partielle à l'intérieur du diagramme des zones de fonctionnement d'un circuit.

6. Procédé selon l'une quelconque des revendications précédentes, dans lequel :
pour chaque moment de mesure (t) la mesure respective de la qualité de transmission comprend une mesure d'un taux d'erreur de transmission respectif relatif à une transmission de signaux numérique par l'intermédiaire de la ligne de transmission de signaux (L1) pour une pluralité de points de travail (WP) à l'intérieur de la plage de paramètres de fonctionnement multidimensionnelle spécifiée ; et
la qualité de transmission est déterminée pour le moment de mesure respectif sur la base des taux d'erreur de transmission (BER) ainsi mesurés associés.

7. Procédé selon la revendication 6, dans lequel la comparaison (245) de la qualité de transmission mesurée à un moment de mesure respectif à une valeur de référence pour la qualité de transmission respective associée préalablement déterminée selon la grandeur de qualité de transmission s'effectue de sorte que la qualité de transmission mesurée au moment de mesure respectif intervient dans la comparaison sous forme d'une valeur moyenne ou valeur médiane, qui résulte d'un calcul de moyenne (225) ou d'une formation de médiane sur la base de cette qualité de transmission mesurée et d'au moins une qualité de transmission relative à la ligne de transmission mesurée à un moment de mesure antérieur par rapport à celui-ci, dans lequel ces qualités de transmission (V) ont été déterminées respectivement selon la grandeur de qualité de transmission.

8. Procédé selon l'une quelconque des revendications précédentes, dans lequel la valeur de référence (R) respective associée à un ou plusieurs moments de mesure est déterminée en fonction d'au moins un des paramètres de fonctionnement.

9. Procédé selon l'une quelconque des revendications précédentes, dans lequel la plage de paramètres de fonctionnement présente respectivement en tant que dimension au moins un des paramètres de fonctionnement suivants :
- un paramètre de fonctionnement, qui caractérise un niveau de signal (U) d'un signal transmis par l'intermédiaire de la ligne de transmission ;
- un paramètre de fonctionnement, qui caractérise une phase de signal (Φ) d'un signal transmis par l'intermédiaire de la ligne de transmission ;
- un paramètre de fonctionnement, qui caractérise une température de fonctionnement du système électronique ou de la ligne de transmission ;
- un paramètre de fonctionnement, qui caractérise un état de vieillissement du système électronique ou de la ligne de transmission ;
- un paramètre de fonctionnement, qui caractérise un(e) ou plusieurs influences ou effets extérieur(e)s, auxquel(le)s le système électronique est exposé.

10. Procédé selon l'une quelconque des revendications précédentes, dans lequel les valeurs de référence (R) pour la qualité de transmission sont établies à différents moments de mesure (t) avant la détermination de la plage partielle (T) dans des conditions de référence déterminées et pour la comparaison suivante aux résultats de la mesure répétée de la qualité de transmission conservées dans une structure de données à l'intérieur d'un dispositif de stockage (130).

11. Procédé selon l'une quelconque des revendications précédentes, dans lequel la valeur respective de l'indicateur de fiabilité (Z) est déterminée de sorte qu'elle indique en fonction du résultat de la comparaison une fiabilité suffisante ou une fiabilité insuffisante.

12. Procédé selon la revendication 11, dans lequel la détermination de la valeur respective de l'indicateur de fiabilité s'effectue sur la base d'un critère de contrôle (P), lequel est adapté de manière dynamique en fonction d'une pluralité de valeurs précédemment déterminées de l'indicateur de fiabilité ou éventuellement de l'indicateur de fiabilité résultant.

13. Procédé selon la revendication 12, dans lequel l'adaptation dynamique du critère de contrôle (P) s'effectue dans le cadre d'un apprentissage machine sur la base des valeurs précédemment déterminées de l'indicateur de fiabilité ou éventuellement de l'indicateur de fiabilité résultant.

14. Procédé selon l'une quelconque des revendications 11 à 13, dans lequel la valeur de l'indicateur de fiabilité (Z) est déterminée en fonction d'un écart (A) établi lors de la comparaison entre la qualité de transmission (V) respective mesurée selon le degré de qualité de transmission et la valeur de référence (R) respective associée sur la base d'un des critères de contrôle (P) suivants :
- au cas où l'écart établi ne passerait pas au-dessous d'une valeur fixe prédéfinie pour l'écart minimal, la valeur de l'indicateur de fiabilité est réglée de sorte qu'elle indique une fiabilité suffisante et dans le cas contraire une fiabilité insuffisante ;
- au cas où l'écart établi ne passerait pas au-dessous d'une valeur fixée en fonction du moment de mesure pour l'écart minimal, la valeur de l'indicateur de fiabilité est réglée de sorte qu'elle indique une fiabilité suffisante et dans le cas contraire une fiabilité insuffisante ;
- au cas où le moment de mesure respectif se situerait avant le moment de l'atteinte d'un état de vieillissement prédéfini du système électronique, la valeur de l'indicateur de fiabilité est réglée de sorte qu'elle indique une fiabilité suffisante et dans le cas contraire une fiabilité insuffisante.

15. Procédé selon l'une quelconque des revendications précédentes, dans lequel :
au moins un composant électronique (K) est disposé dans la ligne de transmission (L1) ; et ;
l'établissement de la qualité de transmission au moment de mesure respectif s'effectue en fonction du type de la au moins une pièce.

16. Procédé selon l'une quelconque des revendications précédentes, présentant en outre :
la mise en œuvre du procédé selon l'une quelconque des revendications précédentes pour la détermination d'un autre indicateur de fiabilité respectif pour les points de mesure sur la base d'une mesure répétée de la qualité de transmission selon la grandeur de qualité de transmission prédéfinie de signaux envoyés par l'intermédiaire d'une seconde ligne de transmission (L2 ; L3) différente de la première au ou à partir du système électronique ; et
la détermination d'un indicateur de fiabilité résultant au moment de mesure respectif pour le système électronique ou au moins une des lignes de transmission en fonction de l'indicateur de fiabilité déterminé pour la première ligne de transmission pour le moment de mesure respectif et de l'autre indicateur de fiabilité déterminé pour ce moment de mesure respectif pour la seconde ligne de transmission.

17. Procédé selon l'une quelconque des revendications précédentes, présentant en outre :
le déclenchement (265) d'une action du système électronique lui-même ou d'une action d'une autre entité agissant sur celui-ci, lorsque (250) selon la valeur établie de l'indicateur de fiabilité ou éventuellement de l'indicateur de fiabilité résultant une fiabilité suffisante du système électronique n'est plus donnée.

18. Dispositif (105) pour la surveillance de la fiabilité d'un système électronique (100a, 100b), dans lequel le dispositif est conçu pour exécuter le procédé (200) selon l'une quelconque des revendications précédentes.

19. Programme informatique, lequel contient des instructions qui, lors de leur exécution sur un ou plusieurs processeurs (125) associés à un dispositif (105) selon la revendication 18, amènent le dispositif (105) à exécuter le procédé (200) selon l'une quelconque des revendications 1 à 17.
